# EUROPÄISCHE PATENTSCHRIFT

(11) **EP 3 807 536 B1**
(45) Veröffentlichungstag und Bekanntmachung des Hinweises auf die Patenterteilung: **02.08.2023**
(21) Anmeldenummer: 19732557.4
(22) Anmeldetag: 12.06.2019
(51) Int. Cl.: F04B 19/00, H10N 35/00

(54) **VERDRÄNGUNGSPUMPENVORRICHTUNG**
POSITIVE DISPLACEMENT PUMP DEVICE
DISPOSITIF DE POMPE VOLUMÉTRIQUE

(30) Priorität: 13.06.2018 DE 102018114166
(43) Veröffentlichungstag der Anmeldung: 21.04.2021
(73) Patentinhaber: ETO MAGNETIC GmbH, 78333 Stockach (DE)
(72) Erfinder: SCHAUTZGY, Maximilian, 88709 Meersburg (DE); SCHIEPP, Thomas, 78606 Seitingen-Oberflacht (DE); LAUFENBERG, Markus, 78333 Stockach (DE)
(74) Vertreter: Daub, Thomas
(86) Internationale Anmeldenummer: PCT/EP2019/065370
(87) Internationale Veröffentlichungsnummer: WO 2019/238768

(56) Entgegenhaltungen:
- DE-A1-102016 110 669
- US-A1- 2016 211 065
- US-A1- 2016 301 293
- US-B1- 9 091 251

## Beschreibung

### Stand der Technik

Die Erfindung betrifft eine Verdrängungspumpenvorrichtung gemäß dem Oberbegriff von Anspruch 1 sowie ein Verfahren gemäß dem Oberbegriff von Anspruch 23.

Aus der US 2016/0301293 A1 ist bereits eine Mikropumpe bekannt, welche zur Förderung ein MSM-Element und eine elektromagnetische Magneteinheit nutzt, wobei die elektromagnetische Magneteinheit in einem Betriebszustand dazu vorgesehen ist, eine lokale longitudinale Verformung des MSM-Elements zur Bereitstellung eines Fördervolumens zu erzeugen. Aus den Dokumenten US 2016/0211065 A1, DE 10 2016 110 669 A1, US 9,091,251 B1 und US 2016/301293 A1 sind weitere Verdrängungspumpen bekannt.

Die Aufgabe der Erfindung besteht insbesondere darin, eine gattungsgemäße Vorrichtung mit verbesserten Eigenschaften hinsichtlich einer Bauweise, insbesondere im Hinblick auf einen Bauraum und/oder eine Zuverlässigkeit bereitzustellen. Die Aufgabe wird erfindungsgemäß durch die Merkmale der Patentansprüche 1 und 23 gelöst, während vorteilhafte Ausgestaltungen und Weiterbildungen der Erfindung den Unteransprüchen entnommen werden können.

### Vorteile der Erfindung

Die Erfindung geht aus von einer Verdrängungspumpenvorrichtung mit zumindest einer Formgedächtniseinheit, welche zumindest ein magnetisches Formgedächtniselement umfasst, welches dazu vorgesehen ist, zumindest ein Medium entlang zumindest einer Förderrichtung zu fördern.

Es wird in einem Aspekt der Erfindung, welcher insbesondere einzeln oder in Kombination mit weiteren Aspekten der Erfindung betrachtet werden kann, vorgeschlagen, dass die Verdrängungspumpenvorrichtung zumindest eine Verformungseinheit aufweist, welche dazu vorgesehen ist, das magnetische Formgedächtniselement zur Bereitstellung eines Fördervolumens zumindest in einem Ruhezustand durch eine in Förderrichtung wirkende Druckkraft und/oder Zugkraft derart zu verformen, dass dieses zumindest einen ersten Teilbereich und zumindest einen zweiten Teilbereich aufweist, welche sich zumindest durch eine magnetische Orientierung voneinander unterscheiden. Hierdurch kann vorteilhaft eine Bauweise der Verdrängungspumpenvorrichtung verbessert werden, da insbesondere auf sich bewegende und damit verschleißanfällige und fehleranfällige Bauteile zur Ausbildung des ersten Teilbereichs und/oder zur Magnetisierung der magnetischen Orientierung der Teilbereiche verzichtet werden kann. Besonders vorteilhaft kann ein Verschleiß von Bauteilen der Verdrängungspumpenvorrichtung verringert und/oder können Wartungsintervalle vergrößert werden. Weiter vorteilhaft kann eine Zuverlässigkeit verbessert werden, da auch in einem Ruhezustand stets ein Fördervolumen zur Aufnahme des Mediums bereitgestellt werden kann. Somit kann insbesondere vermieden werden kann, dass sich ein Medium bei einer insbesondere ungewollten Deaktivierung eines Betriebszustands der Verdrängungspumpenvorrichtung unvorhersehbar verteilt sowie Schäden an der Verdrängungspumpenvorrichtung hervorruft. Weiter vorteilhaft kann eine besonders kompakte Bauweise erzielt werden.

Unter einer "Verdrängungspumpenvorrichtung" soll insbesondere ein, insbesondere funktionstüchtiger, Bestandteil, insbesondere eine Konstruktions- und/oder Funktionskomponente, einer Verdrängungspumpe verstanden werden. Die Verdrängungspumpenvorrichtung bildet insbesondere die Verdrängungspumpe zumindest teilweise und vorzugsweise zumindest zu einem Großteil aus. Alternativ kann die Verdrängungspumpenvorrichtung die Verdrängungspumpe auch vollständig ausbilden. Unter dem Ausdruck "zumindest zu einem Großteil" soll dabei insbesondere zumindest zu 55 %, vorteilhaft zumindest zu 65 %, vorzugsweise zumindest zu 75 %, besonders bevorzugt zumindest zu 85 % und ganz besonders bevorzugt zumindest zu 95 % und insbesondere aber auch vollständig verstanden werden. Unter einer "Verdrängungspumpe" soll insbesondere eine, insbesondere elektrisch betriebene, Pumpe verstanden werden, welche zur Förderung zumindest eines Mediums einen Verdrängungsmechanismus nutzt. Die Verdrängungspumpe weist insbesondere zumindest ein geschlossenes Fördervolumen auf, welches das Medium fördert und welches vorzugsweise dazu vorgesehen ist, ein ungewolltes Zurückströmen des Mediums entgegen der Förderrichtung zu verhindern. Besonders vorteilhaft ist die Verdrängungspumpe selbstansaugend und dazu vorgesehen, selbstständig einen Unterdruck aufzubauen, um das Medium in diese hinein zu fördern, wobei insbesondere auf weitere Unterdruckkomponenten, wie beispielsweise eine zusätzliche Unterdruckpumpe, verzichtet werden kann. Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungsund/oder Betriebszustand erfüllt und/oder ausführt. Insbesondere ist die Verdrängungspumpe als eine Mikropumpe ausgebildet. Unter einer "Mikropumpe" soll insbesondere eine Verdrängungspumpe verstanden werden, welche einen Bauraum von höchstens 25 cm³, vorzugsweise von höchstens 15 cm³ und besonders bevorzugt von höchstens 5 cm³ aufweist. Die Verdrängungspumpenvorrichtung ist insbesondere zur Förderung eines Mediums vorgesehen, welches wenigstens eine Flüssigkeit, wenigstens ein Gas, wenigstens einen Feststoff, insbesondere einen pulverförmigen Feststoff, und/oder ein Gemisch dieser umfasst. Beispielsweise kann das Medium wenigstens eine Flüssigkeit mit einem darin gelösten Feststoff, wie beispielsweise einem Wirkstoff, einem Medikament oder dergleichen, umfassen.

Unter einer "Formgedächtniseinheit" soll insbesondere eine Einheit verstanden werden, welche dazu vorgesehen ist, zumindest einen Formgedächtnis-Effekt zur Förderung des Mediums zu nutzen. Bei dem Formgedächtnis-Effekt, welcher von der Formgedächtniseinheit zur Förderung des Mediums genutzt wird, handelt es sich insbesondere um einen magnetischen Formgedächtnis-Effekt. Alternativ oder zusätzlich könnte die Formgedächtniseinheit einen temperaturabhängigen Formgedächtnis-Effekt nutzen. Zur Förderung eines Mediums ist es denkbar, dass die Verdrängungspumpenvorrichtung zumindest zwei Formgedächtniseinheiten, vorzugsweise zumindest drei Formgedächtniseinheiten und besonders bevorzugt mehrere Formgedächtniseinheiten aufweisen kann. Beispielsweise könnten derartige Formgedächtniseinheiten fluidtechnisch miteinander parallel und/oder in Reihe verbunden sein. Ganz besonders bevorzugt weist die Verdrängungspumpenvorrichtung nur eine einzige Formgedächtniseinheit auf.

Die Formgedächtniseinheit kann insbesondere zumindest zwei, vorzugsweise zumindest drei und besonders bevorzugt mehrere Formgedächtniselemente aufweisen, welche insbesondere separat und/oder miteinander gekoppelt ausgebildet sein können. Ganz besonders bevorzugt weist die Formgedächtniseinheit ein einziges Formgedächtniselement auf. Unter einem "Formgedächtniselement" soll insbesondere ein Element verstanden werden, welches zumindest teilweise, vorzugsweise zumindest zu einem Großteil aus einem Formgedächtnismaterial besteht, welches zumindest eine strukturelle Anisotropie umfasst, die eine Formwandlung, wie beispielsweise durch eine Veränderung der Länge und/oder der Dicke des Elements, zur Folge hat, und/oder zumindest eine magnetische Anisotropie umfasst, die eine Umorientierung einer magnetischen Orientierung zur Folge hat. Insbesondere sind die strukturelle Anisotropie und die magnetische Anisotropie voneinander abhängig und/oder sich gegenseitig bedingend. Insbesondere für den Fall einer Ausgestaltung des Formgedächtniselements als ein magnetisches Formgedächtniselement ist die Umwandlung der Anisotropie zumindest magnetfeldabhängig, und zwar insbesondere von einer Orientierung eines Magnetfelds, welches das Formgedächtniselement durchströmt. Bei dem Formgedächtnismaterial, welches das Formgedächtniselement umfasst, könnte es sich insbesondere um ein magnetisch formveränderliches Material handeln, wie beispielsweise ein magnetostriktives Material. Bevorzugt umfasst das Formgedächtniselement jedoch zumindest ein insbesondere magnetisch wirksames und/oder aktives Formgedächtnismaterial und besonders bevorzugt eine magnetische Formgedächtnislegierung (auch bekannt als MSM-Material = Magnetic Shape Memory). Bevorzugt enthält das magnetische Formgedächtnismaterial dabei Nickel, Mangan und Gallium, welche vorzugsweise eine magnetische Formgedächtnislegierung ausbilden.

Ferner weist die Formgedächtniseinheit insbesondere zumindest einen Mantel auf. Zumindest das Formgedächtniselement ist zumindest teilweise, vorzugsweise zumindest zu einem Großteil und besonders bevorzugt vollständig in dem Mantel angeordnet und/oder von diesem umgeben. Der Mantel ist dazu vorgesehen, das Formgedächtniselement abzudichten. Der Mantel ist insbesondere plastisch und bevorzugt elastisch verformbar. Vorzugsweise besteht der Mantel zumindest teilweise aus einem, insbesondere plastischen und vorzugsweise elastischen Kunststoff.

Zum Austausch des Mediums mit einer Umgebung weist die Formgedächtniseinheit insbesondere zumindest zwei vorzugsweise in Förderrichtung versetzt zueinander angeordnete Mediumdurchlässe auf, welche zum Ein- und/oder Auslass des Mediums vorgesehen sind. Die Mediumdurchlässe sind insbesondere von Ausnehmungen des Mantels gebildet. Vorzugsweise weist die Pumpvorrichtung eine einzige Förderrichtung auf, so dass vorzugsweise ein Mediumdurchlass einen Mediumeinlass ausbildet und zumindest ein weiterer Mediumdurchlass einen Mediumauslass ausbildet. Die Mediumdurchlässe sind vorzugsweise an unterschiedlichen, insbesondere einander gegenüberliegenden, Endabschnitten der Formgedächtniseinheit angeordnet. Unter "einem Endabschnitt" soll insbesondere ein Abschnitt verstanden werden, welcher sich ausgehend von einem freien Ende eines Objekts in das Objekt hinein erstreckt, und zwar insbesondere höchstens um 3 cm, vorzugsweise um höchstens 1 cm und besonders bevorzugt um höchstens 0,25 cm. Insbesondere sind die Mediumdurchlässe auf einer gleichen Seite der Formgedächtniseinheit angeordnet. Ferner kann die Formgedächtniseinheit zwei weitere Mediumdurchlässe aufweisen, welche an einer weiteren Seite der Formgedächtniseinheit angeordnet sind, welche von einer Seite der Formgedächtniseinheit, an welcher die Mediumdurchlässe angeordnet sind, verschieden ist und vorzugsweise dieser gegenüberliegt.

Die Formgedächtniseinheit ist insbesondere zumindest teilweise, vorzugsweise zumindest zu einem Großteil und besonders bevorzugt vollständig als ein längliches Objekt ausgebildet. Insbesondere ist das Formgedächtniselement und/oder der Mantel der Formgedächtniseinheit als ein längliches Objekt ausgebildet. Unter einem "länglichen Objekt" soll insbesondere ein Objekt verstanden werden, das eine Abmessung senkrecht zur Haupterstreckung des Objekts aufweist, welche zumindest um einen Faktor 2, vorzugsweise zumindest um einen Faktor 5 und besonders bevorzugt zumindest um einen Faktor 10 kleiner ist als dessen Haupterstreckung. Unter einer "Haupterstreckung" eines Objekts soll insbesondere eine Erstreckung eines Objekts entlang einer Haupterstreckungsrichtung des Objekts verstanden werden, die vorteilhaft durch einen geometrischen Mittelpunkt und/oder Massenmittelpunkt des Objekts verläuft. Unter einer "Haupterstreckungsrichtung" eines Objekts soll insbesondere eine Richtung verstanden werden, welche parallel zu einer längsten Kante eines kleinsten gedachten Quaders orientiert ist, welcher das Objekt gerade noch vollständig umschließt. Vorzugsweise weist das Formgedächtniselement eine Form eines Stabs auf. Insbesondere in Förderrichtung betrachtet weist das Formgedächtniselement einen viereckigen Querschnitt auf. Der Querschnitt weist insbesondere vier Seitenflächen auf, welche die Seiten der Formgedächtniseinheit definieren. Die Form des Mantels ist insbesondere korrespondierend zur Form des Formgedächtniselements ausgebildet. Vorzugsweise weist der Mantel die Form eines Schlauchs auf. Insbesondere in Förderrichtung betrachtet weist der Mantel einen viereckigen Querschnitt auf.

Die Förderrichtung ist insbesondere zumindest im Wesentlichen parallel zur Haupterstreckungsrichtung zumindest des Formgedächtniselements, des Mantels und/oder der Formgedächtniseinheit. Unter "zumindest im Wesentlichen parallel" soll hier insbesondere eine Ausrichtung einer Richtung relativ zu einer Bezugsrichtung, insbesondere in einer Ebene, verstanden werden, wobei die Richtung und die Bezugsrichtung einen Winkel von 90° insbesondere unter Berücksichtigung einer maximalen Abweichung von kleiner als 8°, vorteilhaft von kleiner als 5° und besonders vorteilhaft von kleiner als 2° einschließen. Vorzugsweise ist die Förderrichtung mit der Haupterstreckungsrichtung zumindest des Formgedächtniselements, des Mantels und/oder der Formgedächtniseinheit identisch.

Unter einem "Ruhezustand" der Verdrängungspumpenvorrichtung soll insbesondere ein Zustand verstanden werden, welcher von einem Betriebszustand, in welchem die Verdrängungspumpenvorrichtung ein Medium aktiv entlang der Förderrichtung fördert, verschieden ist. Insbesondere ist der Ruhezustand ein Zustand, in welchem ein Fördervolumen der Verdrängungspumpenvorrichtung stillsteht. Erfindungsgemäß ist der Ruhezustand ein Zustand, in welchem die Verdrängungspumpenvorrichtung frei von einer Energieversorgung ist, wobei insbesondere kein elektrischer Strom durch diese fließt und/oder keine elektrische Spannung an dieser anliegt.

Unter einer "Verformungseinheit" soll insbesondere eine Einheit verstanden werden, welche zur Verformung zumindest des Formgedächtniselements und vorzugsweise zu Verformung der Formgedächtniseinheit zumindest eine Druckkraft und/oder Zugkraft bereitstellt. Die Verformungseinheit kann dazu insbesondere das Formgedächtniselement intrinsisch oder durch externe Krafteinwirkung verspannen und/oder stauchen. Die Verformungseinheit stellt insbesondere die Druckkraft und/oder Zugkraft durch eine mechanische und/oder magnetische Wechselwirkung mit der Formgedächtniseinheit, und zwar insbesondere mit dem Formgedächtniselement, bereit. Vorzugsweise bildet die Verformungseinheit eine Lagerung aus, in welcher die Formgedächtniseinheit, insbesondere zumindest das Formgedächtniselement, eingespannt ist, aus.

Ein Fördervolumen ist ein Volumen, welches zumindest im Wesentlichen parallel zur Förderrichtung von zumindest einem zweiten Teilbereich begrenzt und vorzugsweise zwischen zwei dem ersten Teilbereich benachbarten zweiten Teilbereichen eingeschlossen ist und/oder zumindest im Wesentlichen senkrecht zur Förderrichtung von dem Mantel eingeschlossen ist. Unter "zumindest im Wesentlichen senkrecht" soll hier insbesondere eine Ausrichtung einer Richtung relativ zu einer Bezugsrichtung, insbesondere in einer Ebene, verstanden werden, wobei die Richtung und die Bezugsrichtung einen Winkel von 0° insbesondere unter Berücksichtigung einer maximalen Abweichung von kleiner als 8°, vorteilhaft von kleiner als 5° und besonders vorteilhaft von kleiner als 2° einschließen.

Der erste Teilbereich und der zweite Teilbereich unterscheiden sich voneinander insbesondere durch unterschiedliche Orientierungen ihrer magnetischen Anisotropie und/oder ihrer strukturellen Anisotropie, welche die verschiedenen magnetischen Orientierungen und/oder Abmessungen dieser bedingt. Unter einer "magnetischen Anisotropie" soll insbesondere das Vorhandensein einer magnetischen Vorzugsrichtung verstanden werden. Insbesondere bewirkt die magnetische Anisotropie eine Kopplung der Magnetisierung an ein Kristallgitter. Unter einer "Orientierung einer magnetischen Anisotropie" soll insbesondere eine Orientierung einer Vorzugsrichtung der magnetischen Anisotropie verstanden werden. Unter einer "strukturellen Anisotropie" soll insbesondere das Vorhandensein einer strukturellen Vorzugsrichtung verstanden werden, wie dies beispielsweise in einem Kristallgitter der Fall ist, welches von einem kubischen Kristallgitter verschieden ausgebildet ist. Unter einer "Orientierung einer strukturellen Anisotropie" soll insbesondere eine Orientierung einer Vorzugsrichtung der strukturellen Anisotropie verstanden werden. Insbesondere sind die Orientierung der magnetischen Anisotropie und der strukturellen Anisotropie oder mit anderen Worten deren jeweilige Vorzugsrichtungen, insbesondere über das Kristallgitter, miteinander verknüpft. Vorzugsweise ist die magnetische Orientierung des ersten Teilbereichs zumindest im Wesentlichen senkrecht zur magnetischen Orientierung des zweiten Teilbereichs. Bevorzugt ist die magnetische Orientierung des ersten Teilbereichs zumindest im Wesentlichen parallel zur Förderrichtung. Weiter bevorzugt ist die magnetische Orientierung des zweiten Teilbereichs zumindest im Wesentlichen parallel zur Förderrichtung.

In einem weiteren Aspekt der Erfindung, welcher insbesondere separat als auch in Kombination mit weiteren Aspekten der Erfindung betrachtet werden kann, wird vorgeschlagen, dass die Verdrängungspumpenvorrichtung zumindest eine dauermagnetische Magneteinheit umfasst, welche dazu vorgesehen ist, zumindest in einem Ruhezustand, das magnetische Formgedächtniselement mit einem Magnetfeld zu beaufschlagen, so dass dieses zumindest einen ersten Teilbereich und zumindest einen zweiten Teilbereich aufweist, welche sich zumindest durch eine magnetische Orientierung voneinander unterscheiden, und zumindest eine elektromagnetische Magneteinheit umfasst, welche dazu vorgesehen ist, zumindest den ersten Teilbereich in Förderrichtung zu bewegen. Hierdurch kann vorteilhaft eine Bauweise der Verdrängungspumpenvorrichtung verbessert werden, da insbesondere auf sich bewegende und damit verschleißanfällige und fehleranfällige Bauteile zur Ausbildung des ersten Teilbereichs und/oder zur Magnetisierung der magnetischen Orientierung der Teilbereiche verzichtet werden kann.

Unter einer "Magneteinheit" soll insbesondere eine Einheit verstanden werden, welche dazu vorgesehen ist, ein auf das Formgedächtniselement einwirkendes Magnetfeld bereitzustellen und/oder zu erzeugen. Vorteilhaft ist die Magneteinheit dazu vorgesehen, ein Magnetfeld bereitzustellen, welches dessen Magnetfeldhauptachse zumindest im Wesentlichen senkrecht und/oder zumindest im Wesentlichen parallel zur Förderrichtung ausgerichtet ist. Besonders bevorzugt ist die Magneteinheit dazu vorgesehen, insbesondere mittels des Magnetfelds, in zumindest einem Betriebszustand eine Verformung des Formgedächtniselements zu bewirken. Ferner ist die Magneteinheit vorteilhaft zumindest teilweise in einem Nahbereich der Formgedächtniseinheit angeordnet. Unter einem "Nahbereich" soll insbesondere ein räumlicher Bereich verstanden werden, welcher aus Punkten gebildet ist, die weniger als ein Drittel, vorzugsweise weniger als ein Viertel, bevorzugt weniger als ein Sechstel und besonders bevorzugt weniger als ein Zehntel der Haupterstreckung der Formgedächtniseinheit von einem Referenzpunkt und/oder einem Referenzbauteil, insbesondere der Formgedächtniseinheit, entfernt sind und/oder die jeweils einen Abstand von höchstens 20 mm, vorzugsweise von höchstens 10 mm und besonders bevorzugt von höchstens 5 mm von einem Referenzpunkt und/oder einem Referenzbauteil, insbesondere der Formgedächtniseinheit, aufweisen.

Die Magneteinheit weist zumindest ein Magnetelement auf, welches als ein elektromagnetisches und/oder dauermagnetisches Magnetelement ausgebildet ist. Insbesondere weist die Magneteinheit zumindest zwei, vorzugsweise zumindest drei und besonders bevorzugt eine Vielzahl von Magnetelementen auf, welche insbesondere zumindest im Wesentlichen identisch ausgebildet sind. Die Magnetelemente sind insbesondere voneinander separat ausgebildet ansteuerbar und/oder vorzugsweise zueinander versetzt, insbesondere in Förderrichtung versetzt, zueinander angeordnet. Unter "zumindest im Wesentlichen identisch" soll insbesondere bis auf Herstellungsund/oder Montagetoleranzen identisch verstanden werden.

Unter einer "dauermagnetischen Magneteinheit" soll insbesondere eine Magneteinheit verstanden werden, bei welcher zumindest ein Magnetelement, vorzugsweise ein Großteil aller Magnetelemente und besonders bevorzugt alle Magnetelemente der Magneteinheit, als dauermagnetische Magnetelemente ausgebildet sind. Vorzugsweise ist eine dauermagnetische Magneteinheit frei von elektromagnetischen Magnetelementen. Unter einem "dauermagnetischen Magnetelement" soll insbesondere ein Magnetelement verstanden werden, welches zumindest teilweise, vorzugsweise zumindest zu einem Großteil und besonders bevorzugt vollständig aus einem Dauermagnetmaterial besteht. Das dauermagnetische Magnetelement behält insbesondere ein vorzugsweise statisches Magnetfeld bei, ohne dass wie bei einem elektromagnetischen Magnetelement ein elektrischer Strom fließt und/oder eine Spannung anliegt. Unter einem "Dauermagnetmaterial" soll insbesondere ein magnetisches Material verstanden werden, welches, insbesondere nach einer anfänglichen Magnetisierung, eine Remanenz aufweist. Vorteilhaft weist das Dauermagnetmaterial dabei eine Remanenzflussdichte von zumindest 0,2 T, insbesondere von zumindest 0,4 T und insbesondere von zumindest 0,6 T, auf. Das Dauermagnetmaterial umfasst insbesondere zumindest ein hartmagnetisches Material, wie beispielsweise zumindest Eisen, zumindest Cobalt, zumindest Nickel, zumindest Ferrit und/oder eine Legierung dieser.

Unter einer "elektromagnetische Magneteinheit" soll insbesondere eine Magneteinheit verstanden werden, bei welcher zumindest ein Magnetelement, vorzugsweise ein Großteil aller Magnetelemente und besonders bevorzugt alle Magnetelemente der Magneteinheit als elektromagnetische Magnetelemente ausgebildet sind. Insbesondere ist eine elektromagnetische Magneteinheit frei von dauermagnetischen Magenelementen. Unter einem "elektromagnetischen Magnetelement" soll insbesondere ein Magnetelement verstanden werden, welches zumindest eine Leiterschleife umfasst, welche in einem Betriebszustand dazu vorgesehen ist, von einem Strom durchflossen zu werden und/oder an welcher eine Spannung anliegt. Insbesondere weist das elektrische Magnetelement zumindest zwei, vorzugsweise zumindest drei und besonders bevorzugt eine Vielzahl von Leiterschleifen aus. Das elektromagnetische Magnetelement ist insbesondere als eine Spule, vorzugsweise eine Luftspule ausgebildet.

Eine Magneteinheit, insbesondere eine als eine dauermagnetische Magneteinheit ausgebildete Magneteinheit, kann insbesondere zumindest teilweise die Verformungseinheit ausbilden, zumindest teilweise einstückig mit dieser ausgebildet sein und/oder mit dieser identisch sein. Dazu kann die Magneteinheit durch ein von ihr bereitgestelltes Magnetfeld, mit welchem dieses die Formgedächtniseinheit beaufschlagt, die magnetische Anisotropie des Formgedächtnismaterials umorientieren, so dass der erste Teilbereich ausgebildet werden kann. Für diesen Fall ist eine Magnetfeldhauptachse der Magneteinheit zumindest im Wesentlichen senkrecht zur Förderrichtung ausgerichtet. Alternativ oder zusätzlich kann die Magneteinheit die strukturelle Anisotropie umorientieren, indem diese durch Bereitstellung eines Magnetfelds mit einer Magnetfeldhauptachse, welche zumindest im Wesentlichen parallel zur Förderrichtung ausgerichtet ist, eine magnetische Wechselwirkung mit der Formgedächtniseinheit hervorruft, woraus eine auf das Formgedächtniselement wirkende Druckkraft und/oder Zugkraft resultiert und somit zumindest der erste Teilbereich ausgebildet werden kann. Darunter, dass ein erstes Objekt und ein zweites Objekt "zumindest teilweise einstückig" miteinander ausgebildet sind, soll insbesondere verstanden werden, dass zumindest ein Element und/oder Teil des ersten Objekts mit zumindest einem Element und/oder Teil des zweiten Objekts einstückig ausgebildet ist. Besonders bevorzugt soll unter einstückig auch einteilig verstanden werden. Unter "einteilig" soll insbesondere in einem Stück geformt verstanden werden. Vorzugsweise wird dieses eine Stück aus einem einzelnen Rohling, einer Masse und/oder einem Guss, besonders bevorzugt in einem Spritzgussverfahren, insbesondere einem Ein- und/oder Mehrkomponenten-Spritzgussverfahren, hergestellt.

Unter einer "Magnetfeldhauptachse" eines Magnetfelds soll insbesondere eine Achse verstanden werden, welche sich entlang einer maximalen Magnetfeldstärke erstreckt. Insbesondere ist die Magnetfeldhauptachse zumindest im Wesentlichen parallel und vorzugsweise koaxial zu einer Symmetrieachse und/oder einer Haupterstreckung eines Magnetelements und/oder einer Magneteinheit, welche das Magnetfeld, welches die Magnetfeldhauptachse umfasst, bereitstellt und/oder erzeugt. Beispielsweise für den Fall eines elektromagnetischen Magnetelements ist eine Magnetfeldhauptachse zumindest im Wesentlichen parallel und/oder koaxial zu einer Symmetrieachse der Leiterschleife, insbesondere der Spule des elektromagnetischen Magnetelements. Ferner ist beispielsweise für den Fall eines dauermagnetischen Magnetelements eine Magnetfeldhauptachse zumindest im Wesentlichen parallel und/oder koaxial zu einer Erstreckung, insbesondere einer Haupterstreckung, des Magnetelements, welche insbesondere sich gegenüberliegende Flächen von Nord- und Südpol auf kürzesten Weg miteinander verbindet.

Insbesondere ist eine Magneteinheit, vorzugsweise eine als elektromagnetische Magneteinheit ausgebildete Magneteinheit, dazu vorgesehen, zumindest den ersten Teilbereich in Förderrichtung zu bewegen. Vorzugsweise schiebt die elektromagnetische Magneteinheit bei einer Aktivierung dieser den ersten Teilbereich vor sich her. Alternativ ist denkbar, dass die elektromagnetische Magneteinheit zumindest teilweise eine Orientierung eines Teilbereichs verändert und somit an verschiedenen Positionen entlang dem Formgedächtniselement Teilbereiche mit verschiedenen magnetischen Orientierungen erzeugt und/oder vernichtet. Insbesondere ist denkbar, dass die elektromagnetische Magneteinheit von der dauermagnetischen Magneteinheit umorientierte Teilbereiche zurückorientiert und in zweite Teilbereiche umwandelt.

Es wird ferner vorgeschlagen, dass der erste Teilbereich eine geringere Abmessung senkrecht zur Förderrichtung aufweist als der zweite Teilbereich. Es kann vorteilhaft auf effiziente und einfache Art und Weise ein Fördervolumen bereitgestellt werden. Insbesondere ist die Abmessung zumindest um 2 %, vorzugsweise zumindest um 5 % und besonders bevorzugt zumindest um 10 % kleiner. Der erste Teilbereich bildet durch die geringere Abmessung im Vergleich zum zweiten Teilbereich zwischen sich und dem das Formgedächtniselement umschließenden Mantel das Fördervolumen aus. Insbesondere ist das Fördervolumen zumindest von einer Seite durch einen benachbarten zweiten Teilbereich begrenzt. Dabei dichtet insbesondere der zweite Teilbereich zusammen mit dem Mantel das Fördervolumen fluiddicht in Förderrichtung ab.

Um ein besonders großes Fördervolumen zu erzielen, könnte der erste Teilbereich sich über einen Großteil einer Erstreckung des magnetischen Formgedächtniselements erstrecken. Besonders bevorzugt wird jedoch vorgeschlagen, dass der erste Teilbereich sich über einen kleinen Bruchteil einer Erstreckung des magnetischen Formgedächtniselements entlang der Förderrichtung erstreckt. Es kann vorteilhaft ein besonders geringes Fördervolumen gefördert und abgegeben werden. Weiter vorteilhaft kann eine Genauigkeit einer abzugebenden Fördermenge verbessert werden. Unter einem "kleinen Bruchteil" soll insbesondere weniger als 25 %, vorzugsweise weniger als 15 % und besonders bevorzugt weniger als 5 % einer Gesamtheit verstanden werden.

Es wird ferner vorgeschlagen, dass das magnetische Formgedächtniselement zumindest zwei erste Teilbereiche und zumindest zwei zweite Teilbereiche aufweist. Hierdurch kann vorteilhaft eine Pumpleistung verbessert werden. Insbesondere kann ein höherer Durchsatz des Mediums erzielt werden. Insbesondere ist jeweils ein erster Teilbereich von zumindest einem zweiten Teilbereich benachbart, insbesondere unmittelbar benachbart. Ferner ist denkbar, dass das magnetische Formgedächtniselement mehrere erste und mehrere zweite Teilbereiche aufweist. Vorzugsweise weist das magnetische Formgedächtniselement eine gerade Anzahl von ersten Teilbereichen und eine ungerade Anzahl von zweiten Teilbereichen auf oder umgekehrt.

Denkbar ist, dass die Verformungseinheit sich zumindest teilweise zumindest im Wesentlichen parallel entlang der Formgedächtniseinheit erstreckend angeordnet sein. Insbesondere um eine Bauweise weiter zu verbessern wird vorgeschlagen, dass die Verformungseinheit zumindest teilweise an einem Endabschnitt der Formgedächtniseinheit angeordnet ist. Vorzugsweise ist die Verformungseinheit an zwei einander gegenüberliegenden Endabschnitten der Formgedächtniseinheit angeordnet, und zwar insbesondere für den Fall, dass die Versorgungseinheit eine Lagerung für die Formgedächtniseinheit ausbildet.

Weiterhin wird vorgeschlagen, dass die Verformungseinheit zumindest teilweise koaxial um das magnetische Formgedächtniselement angeordnet ist. Hierdurch kann vorteilhaft ein Bauraum reduziert werden. Insbesondere für diesen Fall ist die Verformungseinheit von einer Magneteinheit, insbesondere der zuvor genannten Magneteinheit, vorzugsweise der dauermagnetischen Magneteinheit, ausgebildet. Unter der Wendung, dass "zwei Objekte koaxial angeordnet sind", soll insbesondere verstanden werden, dass die Objekte eine gemeinsame Symmetrieachse aufweisen um welche diese vorzugsweise sich gegenseitig umgebend angeordnet sind.

Insbesondere um eine Einstellbarkeit eines Fördervolumens und/oder einer abzugebenden Fördermenge zu erzielen, wird vorteilhaft vorgeschlagen, dass die Verformungseinheit zur Einstellung verschiedener Verformungsgrade der Verformung des magnetischen Formgedächtniselements vorgesehen ist. Insbesondere ist der Verformungsgrad durch eine Variation der von der Verformungseinheit bereitgestellten Zugkraft und/oder Druckkraft variabel einstellbar. Insbesondere kann für den Fall, dass die Versorgungseinheit zumindest ein Magnetelement umfasst, also insbesondere, wenn diese zumindest teilweise einstückig mit der Magneteinheit und/oder von dieser ausgebildet ist, die Zugkraft und/oder die Druckkraft über eine Magnetfeldstärke einstellbar sein. Insbesondere für den Fall, dass ein solches Magnetelement und/oder eine solche Magneteinheit als ein elektromagnetisches Magnetelement und/oder eine elektromagnetische Magneteinheit ausgebildet sind/ist, kann die Magnetfeldstärke und damit insbesondere die Zugkraft und/oder die Druckkraft über einen Strom und/oder eine Spannung, mit welcher diese betrieben ist, einstellbar sein.

Es wird ferner vorgeschlagen, dass die Verformungseinheit zumindest einen Mechanismus aufweist, welcher zur mechanischen Verformung das magnetische Formgedächtniselement mit einer Druckkraft oder einer Zugkraft beaufschlagt. Vorteilhaft kann auf einfache Art und Weise eine Druckkraft und/oder Zugkraft bereitgestellt werden. Es kann insbesondere eine Verlässlichkeit der Verformungseinheit verbessert werden. Besonders bevorzugt umfasst der Mechanismus zumindest ein Stellelement zur Einstellung einer Druckkraft und/oder Zugkraft, mit welcher das Formgedächtniselement beaufschlagt ist. Vorzugsweise ist das Stellelement als eine Stellschraube ausgebildet. Insbesondere bei einer Ausgestaltung als Einstellschraube ist das Stellelement an zumindest einem Gewinde verdrehbar gelagert und derart mit dem magnetischen Formgedächtniselement zumindest gekoppelt und vorzugsweise direkt beaufschlagend angeordnet, so dass ein Verdrehen des Stellelements das magnetische Formgedächtniselement mit einer Druckkraft und/oder Zugkraft beaufschlagt.

Es wird ferner vorgeschlagen, dass die Verformungseinheit zumindest ein insbesondere dauermagnetisches Magnetelement umfasst. Hierdurch kann eine Verlässlichkeit weiter verbessert werden. Insbesondere für diesen Fall können die Magneteinheit und die Verformungseinheit zumindest teilweise einstückig ausgebildet sein.

Es wird ferner vorgeschlagen, dass eine Magnetfeldhauptachse eines von der Verformungseinheit bereitgestellten Magnetfelds zumindest im Wesentlichen parallel zur Förderrichtung orientiert ist. Hierdurch kann eine besonders starke Druckkraft und/oder Zugkraft erzeugt werden.

Es wird ferner vorgeschlagen, dass die Verdrängungspumpenvorrichtung zumindest eine Magneteinheit, insbesondere die zuvor genannte Magneteinheit, umfasst, welche dazu vorgesehen ist, zumindest den ersten Teilbereich entlang der Förderrichtung zu bewegen. Die Magneteinheit stellt insbesondere ein Magnetfeld bereit, welches entlang der Förderrichtung bewegbar ist, um vorzugsweise eine Bewegung des ersten Teilbereichs zu erzeugen. Die Magneteinheit könnte als eine dauermagnetische Magneteinheit ausgebildet sein, welche vorzugsweise zumindest ein entlang der Förderrichtung beweglich gelagertes dauermagnetisches Magnetelement umfasst, um derart das Magnetfeld entlang der Förderrichtung zu bewegen. Beispielsweise könnte die Verdrängungspumpenvorrichtung zur Bewegung des dauermagnetischen Magnetelements einen Aktor umfassen, wie z.B. einen Magnetaktor, der vorzugsweise als ein Linearmotor ausgebildet ist. Bevorzugt ist die Magneteinheit als eine elektromagnetische Magneteinheit ausgebildet, welche mehrere entlang der Förderrichtung separat angeordnete elektromagnetische Magnetelemente umfasst, die separat angesteuert und kaskadenartig in Förderrichtung aktivierbar sind, um ein sich entlang der Förderrichtung bewegendes Magnetfeld zu erzeugen. Insbesondere soll unter "einer Bewegung eines ersten Teilbereichs" wenigstens eine zumindest teilweise Umwandlung und vorzugsweise mehrere Umwandlungen zumindest eines zweiten Teilbereichs in zumindest einen Teil eines ersten Teilbereichs verstanden werden, woraus insbesondere in der Gesamtheit eine Bewegung des ersten Teilbereichs resultiert. Unter "bewegt" soll verstanden werden, dass zumindest ein zweiter Teilbereich zumindest teilweise in einen ersten Teilbereich umgewandelt wird und/oder umgekehrt. Befindet sich insbesondere der erste Teilbereich in einem Nahbereich eines jeweiligen aktivierten Magnetelements der Magneteinheit, ist dieser mit einem Magnetfeld beaufschlagt. Insbesondere da die magnetische Orientierung des ersten Teilbereichs vorzugsweise zumindest im Wesentlichen senkrecht zur Magnetfeldhauptachse des von der Magneteinheit erzeugten Magnetfelds ausgerichtet ist, orientiert sich die magnetische Anisotropie des ersten Teilbereichs im Nahbereich des Magnetelements um. Aufgrund dessen, dass sich insbesondere die strukturelle Anisotropie und die magnetische Anisotropie gegenseitig bedingen, ändert sich damit vorzugsweise auch die strukturelle Anisotropie. Beispielsweise im Nahbereich des externen Magnetfelds wandelt sich somit zumindest ein Teil des ersten Teilbereichs in einen neuen zweiten Teilbereich um. Insbesondere da das Formgedächtniselement durch die Verformungseinheit zumindest im Ruhezustand und vorzugsweise dauerhaft verformt ist, muss sich eine strukturelle und/oder magnetische Anisotropie eines dem ersten Teilbereich vorzugsweise benachbarten zweiten Teilbereichs außerhalb des Nahbereichs des externen Magnetfelds zumindest teilweise räumlich und/oder magnetisch umorientieren, um weiterhin die von der Verformungseinheit durch die Druckkraft und/oder Zugkraft aufgeprägte Verformung des Formgedächtniselements beizubehalten. Demnach wandelt sich insbesondere der zweite Teilbereich außerhalb des Nahbereichs des durch das jeweilige Magnetelement erzeugten externen Magnetfelds zumindest teilweise in einen ersten Teilbereich um. Insgesamt weicht somit der erste Teilbereich vorteilhaft im Nahbereich des externen Magnetfelds diesem aus und bewegt sich entlang der Förderrichtung. Daraufhin kann insbesondere das jeweilige Magnetelement, welches sich ursprünglich im Nahbereich des ersten Teilbereichs befand, deaktiviert werden.

Insbesondere um einen Bauraum weiter zu verringern, wird vorgeschlagen, dass die Magneteinheit, insbesondere die zuvor genannte dauermagnetische Magneteinheit und/oder elektromagnetische Magneteinheit, zumindest teilweise, vorzugsweise zumindest zu einem Großteil und besonders bevorzugt vollständig koaxial um die Formgedächtniseinheit angeordnet ist. Insbesondere ist eine Symmetrieachse und/oder eine Haupterstreckungsrichtung der Magneteinheit und der Formgedächtniseinheit identisch. Besonders bevorzugt ist die Magneteinheit zumindest teilweise, vorzugsweise zumindest zu einem Großteil und besonders bevorzugt vollständig koaxial um die Verformungseinheit angeordnet. Insbesondere sind/ist eine Symmetrieachse und/oder eine Haupterstreckungsrichtung der Magneteinheit und der Verformungseinheit identisch.

Es wird ferner vorgeschlagen, dass die Magneteinheit, insbesondere die vorbezeichnete elektromagnetische Magneteinheit, zumindest ein Magnetelement aufweist, welches als ein elektromagnetisches Magnetelement ausgebildet ist.

Weiterhin wird vorgeschlagen, dass die Magneteinheit, insbesondere die vorbezeichnete dauermagnetische Magneteinheit, zumindest ein erstes Magnetelement und zumindest ein zweites Magnetelement aufweist, welche entlang einer Förderrichtung versetzt zueinander angeordnet sind. Hierdurch können vorteilhaft gezielt verschiedener Teilabschnitte des Formgedächtniselements mit einem Magnetfeld beaufschlagt werden.

Des Weiteren wird vorgeschlagen, dass die Magneteinheit zumindest ein erstes Magnetelement und ein zweites Magnetelement aufweist, welche separat voneinander ansteuerbar sind. Hierdurch kann eine Förderung entlang der Förderrichtung durch eine Ansteuerung der Magnetelemente erzielt werden. Vorzugsweise sind die Magnetelemente als separat voneinander ausgebildete elektromagnetische Magnetelemente ausgebildet, wie beispielsweise als Spulen, welche jeweils zur separaten Ansteuerung mit einem separaten Strom und/oder einer separaten Spannung angesteuert werden können. Insbesondere weist die Verdrängungspumpenvorrichtung zumindest eine Steuereinheit auf. Unter einer "Steuer" soll insbesondere eine Einheit mit zumindest einem elektronischen Steuergerät verstanden werden. Unter einem elektronischen "Steuergerät" soll insbesondere eine Einheit mit einer Prozessoreinheit und mit einer Speichereinheit sowie mit einem in der Speichereinheit gespeicherten Betriebsprogramm verstanden werden. Grundsätzlich kann die Steuer- und/oder Regeleinheit mehrere untereinander verbundene Steuergeräte aufweisen, die vorzugsweise dazu vorgesehen sind, über ein Bus-System, wie insbesondere ein CAN-Bus-System, miteinander zu kommunizieren. Die Steuereinheit ist insbesondere zur Ansteuerung der Magneteinheit vorgesehen und insbesondere zu einer separaten Ansteuerung des jeweiligen Magnetelements der Magneteinheit. Beispielsweise können einzelne Magnetelemente entlang der Förderrichtung angeordnet nacheinander aktiviert und deaktiviert werden, so dass diese zumindest den ersten Teilbereich entlang der Förderrichtung bewegen.

Es wird ferner vorgeschlagen, dass die Verdrängungspumpenvorrichtung zumindest eine weitere Magneteinheit aufweist. Hierdurch kann vorteilhaft eine Ansteuerung weiter verbessert werden. Denkbar ist, dass die weitere Magneteinheit verschieden von der Magneteinheit ausgebildet ist. Ferner ist denkbar, dass die Magneteinheit als eine dauermagnetische Magneteinheit ausgebildet ist, während die weitere Magneteinheit als eine elektromagnetische Magneteinheit ausgebildet ist. Beispielsweise könnte die Magneteinheit, welche insbesondere als eine dauermagnetische Magneteinheit ausgebildet ist, zumindest teilweise, vorzugsweise zumindest zu einem Großteil und besonders bevorzugt vollständig einstückig mit der Verformungseinheit ausgebildet sein und/oder die Verformungseinheit ausbilden. Vorzugsweise ist jedoch zumindest eine der Magneteinheiten stets als eine elektromagnetische Magneteinheit ausgebildet. Besonders bevorzugt sind die Magneteinheit und die weiter Magneteinheit als elektromagnetische Magneteinheiten ausgebildet.

Es wird ferner vorgeschlagen, dass die weitere Magneteinheit entlang der Förderrichtung zumindest teilweise versetzt zur Magneteinheit angeordnet ist. Hierdurch kann vorteilhaft eine Auflösung einer Ansteuerung verbessert und somit ein kontinuierlicherer Förderbetrieb sichergestellt werden. Insbesondere ist zumindest ein Magnetelement der Magneteinheit entlang der Förderrichtung versetzt zum zumindest einen Magnetelement der weiteren Magneteinheit angeordnet. Vorzugsweise sind die Magnetelemente der Magneteinheit und der weiteren Magneteinheit abwechselnd entlang der Förderrichtung zueinander versetzt angeordnet. Insbesondere senkrecht zu einer Förderrichtung betrachtet, ist zumindest ein Magnetelement der Magneteinheit mit zumindest einem Magnetelement der weiteren Magneteinheit überlappend angeordnet.

Um insbesondere eine Kompaktheit der Bauweise weiter zu verbessern, wird ferner vorgeschlagen, dass die weitere Magneteinheit zumindest teilweise koaxial um die Magneteinheit angeordnet ist. Insbesondere sind/ist eine Symmetrieachse und/oder eine Haupterstreckungsrichtung und/oder eine Magnetfeldhauptrichtung der Magneteinheit und der weiteren Magneteinheit identisch.

Es wird zudem vorgeschlagen, dass die Verdrängungspumpenvorrichtung zumindest eine Verstärkungseinheit umfasst, welche dazu vorgesehen ist, ein von der Verformungseinheit und/oder der Magneteinheit bereitgestelltes Magnetfeld zu verstärken. Hierdurch kann eine Einleitung eines Magnetfelds in die Formgedächtniseinheit verbessert werden. Die Verstärkungseinheit weist insbesondere zumindest ein Joch auf. Das Joch bildet insbesondere zumindest teilweise, vorzugsweise zumindest zu einem Großteil einen Magnetfeldkreis aus. Das Joch kann dabei insbesondere aus einem ferromagnetischen Material bestehen, wie beispielsweise Eisen. Alternativ oder zusätzlich kann die Verstärkungseinheit zumindest teilweise die Verformungseinheit ausbilden und/oder mit dieser zumindest teilweise einstückig ausgebildet sein. Beispielsweise kann die Verstärkungseinheit dazu insbesondere zumindest ein dauermagnetisches Magnetelement umfassen.

Um eine besonders kompakte Anordnung von Bauteilen zu erzielen, wird vorgeschlagen, dass die Verstärkungseinheit zumindest die Magneteinheit und/oder die Verformungseinheit zumindest teilweise umgebend angeordnet ist. Unter einer "Verstärkungseinheit" soll insbesondere eine Einheit verstanden werden, welche zumindest einen Magnetfeldkreis umfasst, welcher zu einer Leitung eines magnetischen Felds vorgesehen ist. Die Verstärkungseinheit ist insbesondere zumindest teilweise, vorzugsweise zumindest zu einem Großteil und besonders bevorzugt vollständig koaxial um die Formgedächtniseinheit, die Magneteinheit, die weitere Magneteinheit und/oder die Versorgungseinheit ausgebildet. Insbesondere sind Symmetrieachsen und/oder eine Haupterstreckungsrichtung der Verstärkungseinheit und der Formgedächtniseinheit, der Magneteinheit, der weiteren Magneteinheit und/oder der Verformungseinheit identisch. Bevorzugt ist die Verstärkungseinheit zumindest teilweise spiegelsymmetrisch zur Haupterstreckungsachse der Formgedächtniseinheit angeordnet. Vorzugsweise weist die Verstärkungseinheit zwei Magnetfeldkreise auf, welche vorzugsweise zumindest im Wesentlichen identisch miteinander ausgebildet sind. Die Magnetfeldkreise sind zueinander spiegelsymmetrisch um eine Achse, welche mit der

Haupterstreckungsrichtung der Formgedächtniseinheit identisch ist, angeordnet. Der Magnetfeldkreis weist insbesondere zumindest ein Joch auf. Das Joch weist eine U-Form auf. Das Joch ist zumindest teilweise aus einem magnetisch leitfähigen Material ausgebildet, wie beispielsweise Eisen. Ferner ist denkbar, dass das Joch zumindest teilweise aus einem dauermagnetische Material ausgebildet ist. Bevorzugt weist der Magnetfeldkreis zumindest ein Magnetelement auf. Ein solches Magnetelement des Magnetfeldkreises könnte als ein elektromagnetisches Magnetelement ausgebildet sein. Bevorzugt ist jedoch ein Magnetelement des Magnetfeldkreises als ein dauermagnetisches Magnetelement ausgebildet. Das Magnetelement bildet dabei zumindest einen Schenkel der U-Form des Jochs aus. Vorzugsweise weist der Magnetfeldkreis zumindest zwei Magnetelemente auf, welche im Wesentlichen identisch zueinander ausgebildet sind. Die Magnetelemente bilden vorzugsweise zwei gegenüberliegende Schenkel der U-Form aus. Ferner ist der Magnetfeldkreis und/oder sind beide der Magnetfeldkreise zumindest teilweise von der Formgedächtniseinheit, insbesondere dem Formgedächtniselement, ausgebildet.

Es wird ferner vorgeschlagen, dass die Verdrängungspumpenvorrichtung zumindest eine Ausgleichseinheit aufweist, welche zumindest ein Magnetfeld bereitstellt, welches die Formgedächtniseinheit durchströmt und eine Magnetfeldhauptachse umfasst, welche zumindest quer zur Förderrichtung orientiert ist. Hierdurch kann eine sich im Formgedächtniselement homogen ausbreitendes Magnetfeld erzielt werden. Unter "zumindest quer orientiert" soll insbesondere zumindest von einer parallelen Orientierung verschieden orientiert verstanden werden. Insbesondere soll unter "zumindest quer orientiert" auch zumindest im Wesentlichen senkrecht verstanden werden. Die Ausgleichseinheit ist insbesondere als eine Magneteinheit, insbesondere eine elektromagnetische und/oder dauermagnetische Magneteinheit, ausgebildet. Die Ausgleichseinheit ist dazu vorgesehen, ein von der Magneteinheit der Verdrängungspumpenvorrichtung erzeugtes Magnetfeld bei einer Bewegung des Magnetfelds entlang der Förderrichtung, also insbesondere bei einem Umschalten zwischen einzelnen Magnetelementen der Magneteinheit, auszugleichen. Die Ausgleichseinheit ist vorzugsweise von der Steuereinheit separat zur Magneteinheit ansteuerbar. Es ist denkbar, dass die Magnetfeldhauptachse der Ausgleichseinheit drehbar ist. Beispielsweise kann diese durch verschiedene, zueinander verdreht angeordnete Magnetelemente, insbesondere elektromagnetische Magnetelemente, erzielt werden, welche zueinander separat ansteuerbar sind. Alternativ kann diese durch ein oder mehrere drehbar gelagerte Magnetelemente, insbesondere dauermagnetische Magnetelemente, erzielt werden.

In einem weiteren Aspekt der Erfindung wird ein Verfahren zum Betrieb der Verdrängungspumpenvorrichtung vorgeschlagen, bei dem ein Medium zumindest von einem magnetischen Formgedächtniselement zumindest einer Formgedächtniseinheit zumindest entlang zumindest einer Förderrichtung gefördert wird, wobei in zumindest einem Verfahrensschritt das magnetische Formgedächtniselement zumindest in einem Ruhezustand derart mittels einer Druckkraft und/oder Zugkraft entlang der Förderrichtung verformt wird, dass dieses zumindest einen ersten Teilbereich und zumindest einen zweiten Teilbereich aufweist, welche sich zumindest durch eine magnetische Orientierung voneinander unterscheiden. Hierdurch kann vorteilhaft eine Abgabe einer Fördermenge verbessert werden.

In einem weiteren Aspekt der Erfindung wird ein Verfahren zum Betrieb der Verdrängungspumpenvorrichtung vorgeschlagen, wobei das magnetische Formgedächtniselement von zumindest einer dauermagnetischen Magneteinheit mit einem Magnetfeld beaufschlagt wird, so dass dieses zumindest einen ersten Teilbereich und zumindest einen zweiten Teilbereich aufweist, welche sich zumindest durch eine magnetische Orientierung voneinander unterscheiden, und dass zumindest der erste Teilbereich von zumindest einer elektromagnetischen Magneteinheit in Förderrichtung bewegt wird. Hierdurch kann vorteilhaft eine Abgabe einer Fördermenge verbessert werden.

Die erfindungsgemäße Verdrängungspumpenvorrichtung und/oder das Verfahren zum Betrieb der Verdrängungspumpenvorrichtung soll hierbei nicht auf die oben beschriebene Anwendung und Ausführungsform beschränkt sein. Insbesondere kann die erfindungsgemäße Verdrängungspumpenvorrichtung und/oder dem Verfahren zum Betrieb der Verdrängungspumpenvorrichtung zu einer Erfüllung einer hierin beschriebenen Funktionsweise eine von einer hierin genannten Anzahl von einzelnen Elementen, Bauteilen und Einheiten sowie Verfahrensschritten abweichende Anzahl aufweisen. Zudem sollen bei den in dieser Offenbarung angegebenen Wertebereichen auch innerhalb der genannten Grenzen liegende Werte als offenbart und als beliebig einsetzbar gelten.

### Zeichnungen

Weitere Vorteile ergeben sich aus der folgenden Zeichnungsbeschreibung. In den Zeichnungen sind Ausführungsbeispiele der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: eine Verdrängungspumpe mit einer Verdrängungspumpenvorrichtung in einer schematischen Darstellung,
- Fig. 2: einen Teil der Verdrängungspumpenvorrichtung mit einer Formgedächtniseinheit, einer Verformungseinheit und einer Magneteinheit in einer schematischen Darstellung,
- Fig. 3: einen schematischen Verfahrensablauf eines Verfahrens zum Betrieb der Verdrängungspumpenvorrichtung,
- Fig. 4: ein weiteres Ausführungsbeispiel einer Verdrängungspumpenvorrichtung mit einer Formgedächtniseinheit, welche zumindest zwei erste Teilbereich aufweist, in einer schematischen Darstellung,
- Fig. 5: ein weiteres Ausführungsbeispiel einer Verdrängungspumpenvorrichtung mit einer Magneteinheit und einer Verformungseinheit in einer schematischen Darstellung,
- Fig. 6: ein weiteres Ausführungsbeispiel einer Verdrängungspumpenvorrichtung mit einer Magneteinheit und einer Verformungseinheit in einer schematischen Darstellung,
- Fig. 7: ein weiteres Ausführungsbeispiel einer Verdrängungspumpenvorrichtung mit einer Magneteinheit und einer weiteren Magneteinheit in einer schematischen Darstellung,
- Fig. 8: ein weiteres Ausführungsbeispiel einer Verdrängungspumpenvorrichtung mit einer Verstärkungseinheit, einer Magneteinheit und einer weiteren Magneteinheit in einer schematischen Darstellung,
- Fig. 9: ein weiteres Ausführungsbeispiel einer Verdrängungspumpenvorrichtung mit einer Verstärkungseinheit, einer Magneteinheit und einer weiteren Magneteinheit in einer schematischen Darstellung,
- Fig. 10: ein weiteres Ausführungsbeispiel einer Verdrängungspumpenvorrichtung mit einer Verstärkungseinheit, einer Magneteinheit und einer weiteren Magneteinheit in einer schematischen Darstellung,
- Fig. 11: ein weiteres Ausführungsbeispiel einer Verdrängungspumpenvorrichtung mit einer Formgedächtniseinheit, welche einen ersten Teilbereich umfasst, welcher sich über einen Großteil der Haupterstreckung der Formgedächtniseinheit erstreckt in einer schematischen Darstellung,
- Fig. 12: ein weiteres Ausführungsbeispiel einer Verdrängungspumpenvorrichtung mit einer Ausgleichseinheit in einer schematischen Darstellung,
- Fig. 13: ein weiteres Ausführungsbeispiel einer Verdrängungspumpenvorrichtung mit einer Ausgleichseinheit in einer schematischen Darstellung und
- Fig. 14: ein weiteres Ausführungsbeispiel einer Verdrängungspumpenvorrichtung mit einer dauermagnetischen Magneteinheit und einer elektromagnetischen Magneteinheit in einer schematischen Darstellung

### Beschreibung der Ausführungsbeispiele

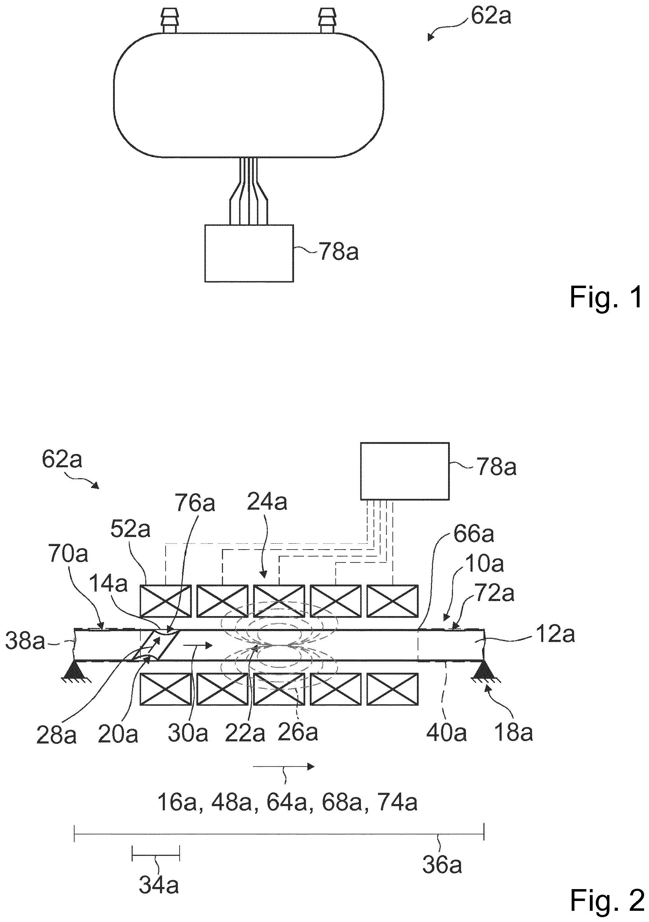

Fig. 1 zeigt eine Verdrängungspumpe 62a mit einer Verdrängungspumpenvorrichtung in einer schematischen Darstellung. Die Verdrängungspumpe 62a ist als eine Mikropumpe ausgebildet. Die Verdrängungspumpe 62a benötigt einen Bauraum von höchstens 25 cm³. Die Verdrängungspumpenvorrichtung bildet die Verdrängungspumpe 62a im vorliegenden Fall vollständig aus. Alternativ könnte ein Bauraum der Verdrängungspumpe 62a wesentlich geringer sein, wobei der Bauraum vorzugsweise höchstens 15 cm³ und besonders bevorzugt höchstens 5 cm³ beträgt. Auch ist die Verwendung der Verdrängungspumpenvorrichtung in einer klassischen Pumpe, also einer Pumpe mit einem größeren Bauraum als 25 cm³ denkbar.

Die Verdrängungspumpenvorrichtung ist dazu vorgesehen, in einem Betriebszustand ein Medium 14a entlang einer Förderrichtung 16a zu fördern. In dem Betriebszustand nutzt die Verdrängungspumpenvorrichtung einen Strom und/oder eine Spannung, um das Medium 14a zu fördern. Ferner ist die Verdrängungspumpenvorrichtung dazu vorgesehen, in einem Ruhezustand ein Medium 14a zu speichern und/oder nicht zu fördern. In dem Ruhezustand ist die Verdrängungspumpenvorrichtung erfindungsgemäß frei von einer Strom- und/oder Spannungsversorgung.

Fig. 2 zeigt einen Teil der Verdrängungspumpenvorrichtung in einer schematischen Darstellung. Die Verdrängungspumpenvorrichtung weist zumindest eine Formgedächtniseinheit 10a auf. Die Formgedächtniseinheit 10a ist zur Förderung des Mediums 14a vorgesehen. Die Formgedächtniseinheit 10a fördert das Medium 14a in Förderrichtung 16a. Zur Förderung des Mediums 14a nutzt die Formgedächtniseinheit 10a einen Formgedächtnis-Effekt. Im vorliegenden Fall nutzt die Formgedächtniseinheit 10a einen magnetischen Formgedächtnis-Effekt. Alternativ oder zusätzlich könnte eine Formgedächtniseinheit auch einen anderen physikalischen Formgedächtnis-Effekt zur Förderung eines Mediums nutzen, wie beispielsweise einen thermischen Formgedächtnis-Effekt.

Die Formgedächtniseinheit 10a ist länglich ausgebildet. Die Formgedächtniseinheit 10a weist eine Haupterstreckungsrichtung 64a auf. Eine Abmessung der Formgedächtniseinheit 10a entlang der Haupterstreckungsrichtung 64a ergibt eine Haupterstreckung der Formgedächtniseinheit 10a. Eine Abmessung der Formgedächtniseinheit 10a senkrecht zur Haupterstreckungsrichtung 64a ist zumindest um einen Faktor 2 kleiner als die Haupterstreckung der Formgedächtniseinheit 10a. Im vorliegenden Fall ist die Abmessung senkrecht zur Haupterstreckung der Formgedächtniseinheit 10a sogar zumindest um den Faktor 10 kleiner als die Haupterstreckung.

Die Formgedächtniseinheit 10a weist zumindest einen Endabschnitt 38a auf. Der Endabschnitt 38a ist an einem freien Ende der Formgedächtniseinheit 10a angeordnet. Der Endabschnitt 38a erstreckt sich von einem freien Ende der Formgedächtniseinheit 10a in diese hinein, und zwar insbesondere höchstens um 1 cm. Im vorliegenden Fall weist die Formgedächtniseinheit 10a zumindest einen weiteren Endabschnitt 40a auf. Der weitere Endabschnitt 40a ist zumindest im Wesentlichen identisch zum Endabschnitt 38a ausgebildet. Der weitere Endabschnitt 40a ist an einem weiteren freien Ende der Formgedächtniseinheit 10a angeordnet. Der weitere Endabschnitt 40a erstreckt sich von einem weiteren freien Ende der Formgedächtniseinheit 10a in diese hinein, und zwar insbesondere höchstens um 1 cm. Die Endabschnitte 38a, 40a liegen einander gegenüber.

Die Formgedächtniseinheit 10a umfasst zumindest einen Mantel 66a. Der Mantel 66a ist zur Anordnung und/oder fluidtechnischen Abdichtung zumindest eines Formgedächtniselements 12a vorgesehen. Der Mantel 66a ist länglich ausgebildet. Der Mantel 66a ist im vorliegenden Fall schlauchförmig ausgebildet. Der Mantel 66a weist eine Haupterstreckungsrichtung 68a auf. Eine Abmessung des Mantels 66a entlang der Haupterstreckungsrichtung 68a ergibt eine Haupterstreckung des Mantels 66a. Eine Abmessung des Mantels 66a senkrecht zur Haupterstreckungsrichtung 68a des Mantels 66a ist zumindest um einen Faktor 2 kleiner als die Haupterstreckung des Mantels 66a. Im vorliegenden Fall ist die Abmessung senkrecht zur Haupterstreckungsrichtung 68a des Mantels 66a sogar zumindest um den Faktor 10 kleiner als dessen Haupterstreckung. Die Haupterstreckung des Mantels 66a entspricht zumindest im Wesentlichen der Haupterstreckung der Formgedächtniseinheit 10a. Die Haupterstreckungsrichtung 68a des Mantels 66a ist im vorliegenden Fall identisch mit der Haupterstreckungsrichtung 64a der Formgedächtniseinheit 10a. Die Haupterstreckungsrichtung 68a des Mantels 66a ist zumindest im Wesentlichen parallel zur Förderrichtung 16a.

Der Mantel 66a weist senkrecht zu dessen Haupterstreckungsrichtung 68a einen viereckigen Querschnitt (nicht dargestellt) auf. Der Mantel 66a weist vier Seitenflächen auf. Der Mantel 66a ist zumindest teilweise plastisch oder elastisch verformbar ausgebildet. Der Mantel 66a besteht zumindest teilweise aus einem Kunststoff.

Zum Austausch des Mediums 14a weist die Formgedächtniseinheit 10a zumindest einen Mediumdurchlass 70a auf. Der Mediumdurchlass 70a ist von einer Ausnehmung des Mantels 66a ausgebildet. Im vorliegenden Fall weist die Formgedächtniseinheit 10a einen weiteren Mediumdurchlass 72a auf. Der weitere Mediumdurchlass 72a ist zumindest im Wesentlichen identisch zu dem Mediumdurchlass 70a ausgebildet. Der Mediumdurchlass 70a und der weitere Mediumdurchlass 72a sind entlang der Förderrichtung 16a versetzt zueinander angeordnet. Der Mediumdurchlass 70a und der weitere Mediumdurchlass 72a sind auf einer gleichen Seite der Formgedächtniseinheit 10a angeordnet. Der Mediumdurchlass 70a ist in dem Endabschnitt 40a angeordnet. Der Mediumdurchlass 70a ist als ein Mediumeinlass ausgebildet. Der weitere Mediumdurchlass 72a ist in dem Endabschnitt 38a angeordnet. Der weitere Mediumdurchlass 72a ist als ein Mediumauslass ausgebildet. Alternativ oder zusätzlich könnte eine Formgedächtniseinheit zusätzliche Mediumdurchlässe, welche insbesondere auf unterschiedlichen, und zwar vorzugsweise gegenüberliegenden Seiten relativ zu der Anordnung der bereits genannten Mediumdurchlässe angeordnet sein könnten, aufweisen, wodurch ein durckausgeglichener Pumpmechanismus erzielbar wäre.

Die Formgedächtniseinheit 10a umfasst zumindest ein Formgedächtniselement 12a. Im vorliegenden Fall weist die Formgedächtniseinheit 10a genau ein Formgedächtniselement 12a auf. Alternativ ist es jedoch denkbar, dass eine Formgedächtniseinheit zumindest zwei oder mehrere Formgedächtniselemente aufweisen kann, welche separat und/oder miteinander gekoppelt ausgebildet sind, wodurch insbesondere größere Fördervolumen realisierbar sein könnten. Auch könnten mehrere Teilformgedächtniselemente ein Formgedächtniselement ausbilden.

Das Formgedächtniselement 12a ist länglich ausgebildet. Das Formgedächtniselement 12a weist eine Haupterstreckungsrichtung 74a auf. Eine Abmessung des Formgedächtniselements 12a entlang der Haupterstreckungsrichtung 74a ergibt eine Haupterstreckung des Formgedächtniselements 12a. Eine Abmessung des Formgedächtniselements 12a senkrecht zur Haupterstreckungsrichtung 74a ist zumindest um einen Faktor 2 kleiner als die Haupterstreckung des Formgedächtniselements 12a. Im vorliegenden Fall ist die Abmessung senkrecht zur Haupterstreckungsrichtung 74a des Formgedächtniselements 12a sogar zumindest um den Faktor 10 kleiner als die Haupterstreckung. Die Haupterstreckung des Formgedächtniselements 12a entspricht zumindest im Wesentlichen der Haupterstreckung der Formgedächtniseinheit 10a. Die Haupterstreckungsrichtung 74a des Formgedächtniselements 12a ist identisch mit der Haupterstreckungsrichtung 68a des Mantels 66a und/oder der Haupterstreckungsrichtung 64a der Formgedächtniseinheit 10a. Die Haupterstreckungsrichtung 74a des Formgedächtniselements 12a ist zumindest im Wesentlichen parallel zur Förderrichtung 16a.

Das Formgedächtniselement 12a weist eine Form eines Stabs auf. Das Formgedächtniselement 12a weist senkrecht zur Förderrichtung 16a einen viereckigen Querschnitt auf (nicht dargestellt). Alternativ könnte das Formgedächtniselement einen rechteckigen oder runden Querschnitt aufweisen. Das Formgedächtniselement 12a ist in dem Mantel 66a angeordnet. Der Mantel 66a umgibt das Formgedächtniselement 12a von vier Seiten. Der Mantel 66a dichtet das Formgedächtniselement 12a, vorzugsweise zumindest zwischen den Endabschnitten 38a, 40a, ab.

Das Formgedächtniselement 12a ist im vorliegenden Fall als ein magnetisches Formgedächtniselement ausgebildet. Das Formgedächtniselement 12a ist zumindest teilweise aus einem Formgedächtnismaterial gebildet. Bei dem Formgedächtnismaterial handelt es sich um ein magnetisch wirksames und/oder aktives Formgedächtnismaterial. Das Formgedächtnismaterial ist eine magnetische Formgedächtnislegierung (auch bekannt als MSM-Material = Magnetic Shape Memory). Das Formgedächtnismaterial umfasst dabei Nickel, Mangan und Gallium. Alternativ könnte es sich bei dem Formgedächtnismaterial auch um ein magnetostriktives Material handeln.

Das Formgedächtnismaterial weist eine strukturelle Anisotropie auf. Ferner weist das Formgedächtnismaterial eine magnetische Anisotropie auf. Die strukturelle Anisotropie und die magnetische Anisotropie sind sich gegenseitig bedingend. Eine Verformung des Formgedächtniselements 12a, welches das Formgedächtnismaterial umfasst, ist zumindest durch eine strukturelle Umorientierung der strukturellen Anisotropie kompensierbar und hat eine in zumindest im Wesentlichen gleichem Maß entsprechende Umorientierung einer magnetischen Orientierung der magnetischen Anisotropie zur Folge. Umgekehrt ist ein auf das Formgedächtniselement 12a, welches das Formgedächtnismaterial umfasst, wirkendes externes Magnetfeld durch zumindest eine bereichsweise magnetische Umorientierung der magnetischen Anisotropie ausgleichbar und hat im zumindest im Wesentlichen gleichen Maß eine entsprechende Umorientierung einer strukturellen Orientierung der strukturellen Anisotropie zur Folge.

Eine zumindest im Ruhezustand der Verdrängungspumpenvorrichtung auf das Formgedächtniselement 12a einwirkende Druckkraft und/oder Zugkraft hat die Ausbildung von zumindest zwei verschiedenen Teilbereichen 20a, 22a des Formgedächtniselements 12a zur Folge, und zwar eines ersten Teilbereichs 20a und zumindest eines zweiten Teilbereichs 22a. Dabei unterscheiden sich die Teilbereiche 20a, 22a durch ihre jeweilige strukturelle Orientierung der strukturellen Anisotropie und/oder magnetische Orientierung der magnetischen Anisotropie voneinander. Ferner kann eine derartige dauerhafte Verformung und/oder ein einwirkendes externes Magnetfeld dauerhaft zu Ausbildung der Teilbereiche 22a, 22a führen.

Zur Verformung des Formgedächtniselements 12a zumindest im Ruhezustand und insbesondere zur dauerhaften Verformung weist die Verdrängungspumpenvorrichtung zumindest eine Verformungseinheit 18a auf. Die Verformungseinheit 18a ist dazu vorgesehen, das magnetische Formgedächtniselement 12a zur Bereitstellung eines Fördervolumens 76a zumindest in einem Ruhezustand durch eine Druckkraft und/oder Zugkraft zu verformen. Die Druckkraft und/oder Zugkraft ist dabei in Förderrichtung 16a gerichtet.

Im vorliegenden Fall ist die Verformungseinheit 18a an den Endabschnitten 38a, 40a der Formgedächtniseinheit 10a angeordnet. Die Verformungseinheit 18a bildet eine Lagerung für die Formgedächtniseinheit 10a aus. Die Verformungseinheit 18a spannt und/oder dehnt die Formgedächtniseinheit 10a insbesondere dauerhaft, so dass daraus resultierend zumindest im Ruhezustand und vorzugsweise dauerhaft das Formgedächtniselement 12a mit einer Druckkraft und/oder einer Zugkraft beaufschlagt ist.

Ein Verformungsgrad des Formgedächtniselements 12a und damit ein bereitgestelltes Fördervolumen 76a ist korreliert mit der Stärke der Druckkraftkraft und/oder der Zugkraft. Der Verformungsgrad der resultierenden Verformung ist mittels der Stärke der Druckkraft und/oder Zugkraft einstellbar.

Alternativ oder zusätzlich sind weitere Ausgestaltungen der Verformungseinheit denkbar, wobei beispielsweise durch eine Ausgestaltung der Verformungseinheit als eine Magneteinheit ein externes Magnetfeld zur Verformung genutzt werden kann, um insbesondere eine Druckkraft und/oder Zugkraft zu erzeugen. Für diesen Fall wäre ein Verformungsgrad eines Formgedächtniselements korreliert mit der Stärke des Magnetfelds und/oder insbesondere einer durch das Magnetfeld erzeugten und auf das Formgedächtniselement einwirkenden Druckkraft und/oder Zugkraft.

Aus der Verformung des Formgedächtniselements 12a durch die Verformungseinheit 18a ergeben sich zumindest zwei Teilbereiche 20a, 22a. Das magnetische Formgedächtniselement 12a weist zumindest den ersten Teilbereich 20a auf. Der erste Teilbereich 20a weist senkrecht zur Förderrichtung 16a eine erste Abmessung auf. Das magnetische Formgedächtniselement 12a weist zumindest einen zweiten Teilbereich 22a auf. Der zweite Teilbereich 22a weist senkrecht zur Förderrichtung 16a eine zweite Abmessung auf. Die erste Abmessung des ersten Teilbereichs 20a senkrecht zur Förderrichtung 16a ist kleiner als die zweite Abmessung des zweiten Teilbereichs 22a senkrecht zur Förderrichtung 16a. Der erste Teilbereich 20a erstreckt sich über einen kleinen Bruchteil 34a einer Erstreckung 36a des magnetischen Formgedächtniselements 12a entlang der Förderrichtung 16a. Im vorliegenden Fall erstreckt sich der erste Teilbereich 20a über höchstens 25 % der Haupterstreckung des Formgedächtniselements 12a. Der zweite Teilbereich 22a erstreckt sich über einen Großteil einer Erstreckung des magnetischen Formgedächtniselements 12a in Förderrichtung 16a. Im vorliegenden Fall erstreckt sich der zweite Teilbereich 22a über wenigstens 50 % der Haupterstreckung des Formgedächtniselements 12a. Demnach unterscheiden sich der erste Teilbereich 20a und der zweite Teilbereich 22a zumindest durch ihre jeweiligen Abmessungen und/oder Erstreckungen voneinander.

Der erste Teilbereich 20a und der Mantel 66a schließen ein Fördervolumen 76a ein, welches zur Förderung des Mediums 14a vorgesehen ist. Der erste Teilbereich 20a und der zweite Teilbereich 22a sind zueinander benachbart angeordnet. Das Fördervolumen 76a ergibt sich demnach durch die unterschiedlichen Abmessungen des ersten Teilbereichs 20a im Vergleich zum zweiten Teilbereich 22a senkrecht zur Förderrichtung 16a. Im vorliegenden Fall weist das Formgedächtniselement 12a zwei zweite Teilbereiche 22a auf, welche den ersten Teilbereich 20a, und insbesondere das von diesem bereitgestellte Fördervolumen 76a begrenzen. Abhängig von einer Ausgestaltung und insbesondere einer Förderleistung der Verdrängungspumpenvorrichtung sind Ausgestaltungen mit mehreren ersten und zweiten Teilbereichen denkbar.

Der erste Teilbereich 20a weist eine erste magnetische Orientierung 28a auf. Der zweite Teilbereich 20a weist eine zweite magnetische Orientierung 30a auf. Die erste magnetische Orientierung 28a des ersten Teilbereichs 20a und die zweite magnetische Orientierung 30a des zweiten Teilbereichs 22a sind voneinander verschieden. Die erste magnetische Orientierung 28a des ersten Teilbereichs 20a ist im vorliegenden Fall zumindest im Wesentlichen senkrecht zur Förderrichtung 16a. Die zweite magnetische Orientierung 30a des zweiten Teilbereichs 22a ist im vorliegenden Fall zumindest im Wesentlichen parallel zur Förderrichtung 16a. Die erste magnetische Orientierung 28a des ersten Teilbereichs 20a ist zumindest im Wesentlichen senkrecht zur zweiten magnetischen Orientierung 30a des zweiten Teilbereichs 22a. Demnach unterscheiden sich der erste Teilbereich 20a und der zweite Teilbereich 22a zumindest durch ihre jeweiligen magnetischen Orientierungen 28a, 30a voneinander.

Die Verdrängungspumpenvorrichtung weist zumindest eine Magneteinheit 24a auf. Im vorliegenden Fall ist die Magneteinheit 24a dazu vorgesehen, den ersten Teilbereich 20a entlang der Förderrichtung 16a zu bewegen. Die Magneteinheit 24a ist dazu vorgesehen, ein externes Magnetfeld 26a bereitzustellen, welches entlang der Förderrichtung 16a bewegbar ist. In dem Betriebszustand Verdrängungspumpenvorrichtung beaufschlagt die Magneteinheit 24a die Formgedächtniseinheit 10a, und zwar insbesondere das Formgedächtniselement 12a der Formgedächtniseinheit 10a, mit dem externen Magnetfeld 26a. Alternativ oder zusätzlich kann die Verdrängungspumpenvorrichtung weitere Magneteinheiten aufweisen. Beispielsweise könnte eine weitere Magneteinheit zumindest teilweise eine Verformungseinheit ausbilden und/oder zumindest teilweise mit dieser einstückig ausgebildet sein. Ferner ist denkbar, dass eine weitere Magneteinheit zu einer dauerhaften magnetischen Umorientierung der magnetischen Orientierung der Teilbereiche vorgesehen sein kann.

Eine Magnetfeldhauptachse 48a des externen Magnetfelds 26a der Magneteinheit 24a ist zumindest im Wesentlichen parallel zur Förderrichtung 16a. Die Magnetfeldhauptachse 48a des externen Magnetfelds 26a ist zumindest im Wesentlichen senkrecht zur ersten magnetischen Orientierung 28a des ersten Teilbereichs 20a. Die Magnetfeldhauptachse 48a des externen Magnetfelds 26a ist zumindest im Wesentlichen parallel zur zweiten magnetischen Orientierung 30a des zweiten Teilbereichs 22a. Ferner ist denkbar, dass eine Hauptachse eines weiteren Magnetfelds ebenfalls zumindest im Wesentlichen parallel zur Förderrichtung sein kann, und zwar insbesondere für den Fall, dass die weitere Magneteinheit zumindest teilweise eine Verformungseinheit ausbildet und/oder zumindest teilweise einstückig mit dieser ausgebildet ist. Ferner könnte eine weitere Magneteinheit, welche zur magnetischen Umorientierung der Teilbereiche vorgesehen ist, eine Magnetfeldhauptachse aufweisen, welche zumindest im Wesentlichen senkrecht zur Förderrichtung orientiert ist.

Die Magneteinheit 24a erstreckt sich entlang der Förderrichtung 16a zumindest im Wesentlichen parallel zur Formgedächtniseinheit 10a. Die Magneteinheit 24a ist koaxial um das magnetische Formgedächtniselement 12a angeordnet. Eine Symmetrieachse und/oder eine Haupterstreckungsrichtung der Formgedächtniseinheit 10a, insbesondere des Formgedächtniselements 10a und der Magneteinheit 24a, ist identisch. Alternativ oder zusätzlich könnten die Magneteinheit und/oder weitere Magneteinheiten zumindest teilweise koaxial um eine Verformungseinheit oder weitere Bauteile der Verdrängungspumpenvorrichtung angeordnet sein.

Die Magneteinheit 24a weist zumindest ein Magnetelement 52a auf. Das Magnetelement 52a ist koaxial um die Formgedächtniseinheit 10a angeordnet. Das Magnetelement 52a ist als ein elektromagnetisches Magnetelement 52a ausgebildet. Im vorliegenden Fall ist das Magnetelement 52a als Luftspule ausgebildet. Eine Symmetrieachse des Magnetelements 52a ist zumindest im Wesentlichen parallel zur Förderrichtung 16a. Die Symmetrieachse des Magnetelements 52a definiert die Magnetfeldhauptachse 48a des externen Magnetfelds 26a.

Im vorliegenden Fall weist die Magneteinheit 24a fünf Magnetelemente 52a auf. Die Magnetelemente 52a sind zumindest im Wesentlichen identisch zueinander ausgebildet. Die Magnetelemente 52a sind entlang der Förderrichtung 16a zueinander angeordnet. Die Magneteinheit 24a ist im vorliegenden Fall frei von dauermagnetisch ausgebildeten Magnetelementen 52a. Demnach handelt es sich bei der vorliegenden Magneteinheit 24a um eine elektromagnetische Magneteinheit. Alternativ oder zusätzlich könnte eine Magneteinheit jedoch zumindest ein dauermagnetisches Magnetelement umfassen.

Die Magnetelemente 52a sind voneinander separat ansteuerbar. Um das externe Magnetfeld 26a der Magneteinheit 24a entlang der Förderrichtung 16a zu bewegen, sind die Magnetelemente 52a kaskadenartig nacheinander in Förderrichtung 16a ansteuerbar. Eine Anzahl von Magnetelementen kann dabei von einer im vorliegenden Ausführungsbeispiel dargestellten Anzahl abweichen und insbesondere abhängig von einer Dimensionierung der Magnetelemente und/oder einer Dimensionierung der Formgedächtniseinheit sein. Alternativ oder zusätzlich ist denkbar, dass insbesondere bei einer Ausgestaltung der Magneteinheit als eine dauermagnetische Magneteinheit das Magnetfeld durch aktorische Bewegung der Magnetelemente verschiebbar sein könnte.

Die Verdrängungspumpenvorrichtung weist zumindest eine Steuereinheit 78a auf. Die Steuereinheit 78a ist zumindest zur Ansteuerung der Magneteinheit 24a vorgesehen. Die Steuereinheit 78a ist zumindest zur separaten Ansteuerung der Magnetelemente 52a der Magneteinheit 24a vorgesehen. Denkbar ist, dass die Steuereinheit zumindest eine vorgegebene oder von einem Bediener vorgebbare Fördermenge als zumindest einen Steuerparameter nutzt. Ferner können die Steuereinheiten zur Steuerung weiterer Komponenten der Verdrängungspumpenvorrichtung vorgesehen sein. Beispielsweise könnte die Verformungseinheit ansteuerbar sein, um insbesondere einen Verformungsgrad einzustellen, welcher mit dem Fördervolumen 76a korreliert ist.

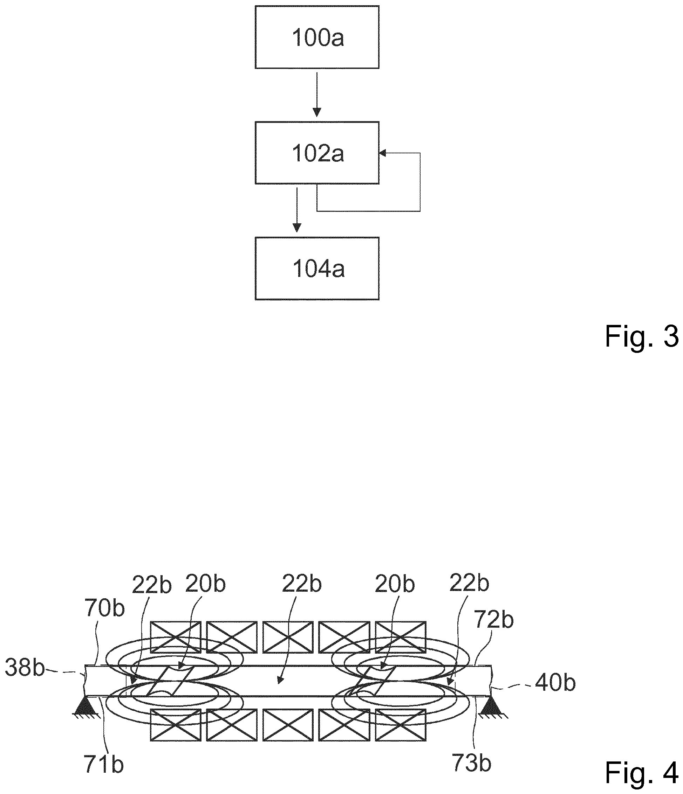

In Fig. 3 ist ein schematischer Verfahrensablauf eines Verfahrens zum Betrieb der Verdrängungspumpenvorrichtung dargestellt. Das Verfahren und insbesondere die darin enthaltenen Verfahrensschritte 100a, 102a, 104a sind in der Steuereinheit 78a hinterlegt und/oder mit dieser ausführbar.

Das Verfahren umfasst einen ersten Verfahrensschritt 100a. Das Formgedächtniselement 12a weist einen ursprünglichen zweiten Teilbereich 22a auf. Der ursprüngliche zweite Teilbereich 22a erstreckt sich über die gesamte Haupterstreckung des Formgedächtniselements 12a. In dem Verfahrensschritt 100a wird die Formgedächtniseinheit 10a von der Verformungseinheit 18a in Förderrichtung 16a mit einer Druckkraft und/oder Zugkraft beaufschlagt. Die Formgedächtniseinheit 10a wird durch die Verformungseinheit 18a in einem Ruhezustand und insbesondere dauerhaft verformt und weist somit eine Verformung auf. Das Formgedächtniselement 12a der Formgedächtniseinheit 10a verformt sich durch eine zumindest teilweise Umorientierung seiner strukturellen Anisotropie. Da die strukturelle Anisotropie und die magnetische Anisotropie sich gegenseitig bedingen, ordnet sich im gleichen Maße teilweise die magnetische Anisotropie um. Derart wandelt sich zumindest ein Teil des ursprünglichen zweiten Teilbereichs 22a in einen ersten Teilbereich 20a um. Der ursprüngliche zweite Teilbereich 22a wird in einen ersten Teilbereich 20a und zwei zweite Teilbereiche 22a aufgeteilt. Es bildet sich ein Fördervolumen 76a zwischen dem Mantel 66a und dem ersten Teilbereich 20a aus, welches von dem benachbarten zweiten Teilbereich 22a begrenzt ist. Im vorliegenden Fall erfolgt die Beaufschlagung mit der Druckkraft und/oder Zugkraft durch Einspannen der Formgedächtniseinheit 10a in der von der Verformungseinheit 18a ausgebildeten Lagerung. Dies kann beispielsweise bei einer Herstellung und/oder Montage der Verdrängungspumpenvorrichtung geschehen. Ferner ist denkbar, dass ein Verformungsgrad mittels einer stärker wirkenden Druckkraft und/oder Zugkraft, welche auf das Formgedächtniselement 12a wirkt, einstellbar ist. Beispielsweise ist denkbar, dass dies mittels eines Mechanismus, welcher beispielsweise eine Einstellschraube umfasst, mit welcher die Formgedächtniseinheit gekoppelt ist, erzielt werden kann. Insbesondere für den Fall, dass die Verformungseinheit zumindest teilweise von einer Magneteinheit ausgebildet ist und/oder zumindest teilweise einstückig mit einer Magneteinheit ausgebildet ist, kann der Verformungsgrad durch eine Magnetfeldstärke eines zur Verformung des Formgedächtniselements bereitgestellten Magnetfelds eingestellt werden. Ferner ist denkbar, dass sich zur Kompensierung der Verformung mehrere erste Teilbereiche ausbilden. Um jedoch die Ausbildung eines einzigen ersten Teilbereichs zu erzielen, kann/können die Magneteinheit, und zwar insbesondere alle Magnetelemente der Magneteinheit, gleichzeitig aktiviert werden, um die ersten Teilbereiche zu einem einzigen ersten Teilbereich zu vereinen.

Das Verfahren umfasst zumindest einen weiteren Verfahrensschritt 102a. Der weitere Verfahrensschritt 102a kann nach dem Verfahrensschritt 100a erfolgen. Für den Fall, dass die Verdrängungspumpenvorrichtung bereits hergestellt ist und/oder sich bereits im Betrieb befindet, kann auf den Verfahrensschritt 100a verzichtet werden und insbesondere das Verfahren mit dem weiteren Verfahrensschritt 102a begonnen und/oder dieser wiederholt durchgeführt werden. Die Steuereinheit 78a aktiviert zumindest ein sich in einem Nahbereich des ersten Teilbereich 20a befindliches Magnetelement 52a, um das externe Magnetfeld 26a bereitzustellen. Das jeweilige Magnetelement 52a beaufschlagt den ersten Teilbereich 20a mit dem externen Magnetfeld 26a. Da die magnetische Orientierung 28a des ersten Teilbereichs 20a zumindest im Wesentlichen senkrecht zur Magnetfeldhauptachse 48a des externen Magnetfelds 26a ausgerichtet ist, orientiert sich die magnetische Anisotropie des ersten Teilbereichs 20a im Nahbereich des aktivierten Magnetelements 52a um. Aufgrund der Tatsache, dass sich die strukturelle Anisotropie und die magnetische Anisotropie gegenseitig bedingen, ändert sich damit auch die strukturelle Anisotropie. Im Nahbereich des Magnetelements 52a wandelt sich somit zumindest ein Teil des ersten Teilbereichs 20a in einen neuen zweiten Teilbereich 22a um. Da das Formgedächtniselement 12a durch die Verformungseinheit 18a dauerhaft verformt ist, muss sich die Anisotropie des dem ersten Teilbereich 20a benachbarten zweiten Teilbereichs 22a außerhalb des Nahbereichs des Magnetfeldelements zumindest teilweise räumlich und/oder magnetisch umorientieren, um weiterhin die von der Verformungseinheit 18a aufgezwungene Verformung des Formgedächtniselements 12a beizubehalten. Demnach wandelt sich der zweite Teilbereich 22a außerhalb des Nahbereichs des aktivierten Magnetelements 52a in einen neuen ersten Teilbereich 20a um. Insgesamt weicht somit der erste Teilbereich 20a im Nahbereich des aktivierten Magnetelements 52a diesem aus und verschiebt sich entlang der Förderrichtung 16a.

Daraufhin kann das jeweilige Magnetelement 52a, welches sich ursprünglich im Nahbereich des ersten Teilbereichs 20a befand, deaktiviert werden.

Der Verfahrensschritt 102a wird für jedes Magnetelement 52a der Magneteinheit 24a wiederholt. Durch eine kaskadenartige Ansteuerung und insbesondere Aktivierung der entlang der Förderrichtung 16a versetzt zueinander angeordneten Magnetelemente 52a der Magneteinheit 24a kann somit erzielt werden, dass sich der erste Teilbereich 20a entlang der Förderrichtung 16a bewegt. Der Verfahrensschritt 102a wird wiederholt, bis das Fördervolumen 76a von dem Endabschnitt 38a zum Endabschnitt 40a gefördert wurde.

Das Verfahren umfasst zumindest einen weiteren Verfahrensschritt 104a. Im Verfahrensschritt 104a wird eine Förderung des Mediums 14a insbesondere nach Erreichen einer vorgesehenen Fördermenge beendet. Die Förderung wird durch Deaktivierung der Magneteinheit 24a beendet. Durch die zumindest im Ruhezustand und vorzugsweise dauerhafte Verformung der Formgedächtniseinheit 10a mittels der Verformungseinheit 18a kann ein etwaiger Rückstand des Mediums 14a in einem ersten Teilbereich 20a innerhalb der Formgedächtniseinheit 10a gespeichert werden.

In den Fig. 4 bis 14 sind weitere Ausführungsbeispiele der Erfindung gezeigt. Die nachfolgenden Beschreibungen beschränken sich im Wesentlichen auf die Unterschiede zwischen den Ausführungsbeispielen, wobei bezüglich gleichbleibender Bauteile, Merkmale und Funktionen auf die Beschreibung des Ausführungsbeispiels der Fig. 1 bis 3, sowie insbesondere der jeweils vorhergehenden Ausführungsbeispiele, verwiesen werden kann. Zur Unterscheidung der Ausführungsbeispiele ist der Buchstabe a in den Bezugszeichen des Ausführungsbeispiels in den Fig. 1 bis 3 durch die Buchstaben b bis I in den Bezugszeichen der Ausführungsbeispiele der Fig. 4 bis 14 ersetzt. Bezüglich gleich bezeichneter Bauteile, insbesondere in Bezug auf Bauteile mit gleichen Bezugszeichen, kann grundsätzlich auch auf die Zeichnungen und/oder die Beschreibung des Ausführungsbeispiels der Fig. 1 bis 3, sowie insbesondere der jeweils vorhergehenden Ausführungsbeispiele, verwiesen werden.

Fig. 4 zeigt ein weiteres Ausführungsbeispiel der Verdrängungspumpenvorrichtung in einer schematischen Darstellung. Dieses unterscheidet sich im Wesentlichen durch eine Ansteuerung einer Magneteinheit 24b, einer Anzahl von Teilbereichen 20b, 22b und/oder einer Anzahl von Mediumdurchlässen 70b, 72b der Verdrängungspumpenvorrichtung.

Im vorliegenden Fall weist das Formgedächtniselement 12b zwei erste Teilbereiche 20b auf. Ferner weist das Formgedächtniselement 12b drei zweite Teilbereiche 22b auf. Zur gleichzeitigen Bewegung der zwei ersten Teilbereiche 20b werden stets zwei der Magnetelemente 52b der Magneteinheit 24b von der Steuereinheit 78b gleichzeitig aktiviert und insbesondere kaskadenartig in Förderrichtung 16b angesteuert.

Im vorliegenden Fall weist die Formgedächtniseinheit 10b zwei Mediumdurchlässe 70b, 71b im Endabschnitt 38b auf. Die Mediumdurchlässe 70b, 71b befinden sich auf gegenüberliegenden Seiten der Formgedächtniseinheit 10b. Die Mediumdurchlässe 70b, 71b im Endabschnitt 38b sind als Mediumeinlässe ausgebildet. Ferner weist die Formgedächtniseinheit 10b zwei weitere Mediumdurchlässe 72b, 73b im weiteren Endabschnitt 40b auf. Die weiteren Mediumdurchlässe 72b, 73b befinden sich auf gegenüberliegenden Seiten. Die weiteren Mediumdurchlässe 72b, 73b im weiteren Endabschnitt 40b sind als Mediumauslässe ausgebildet.

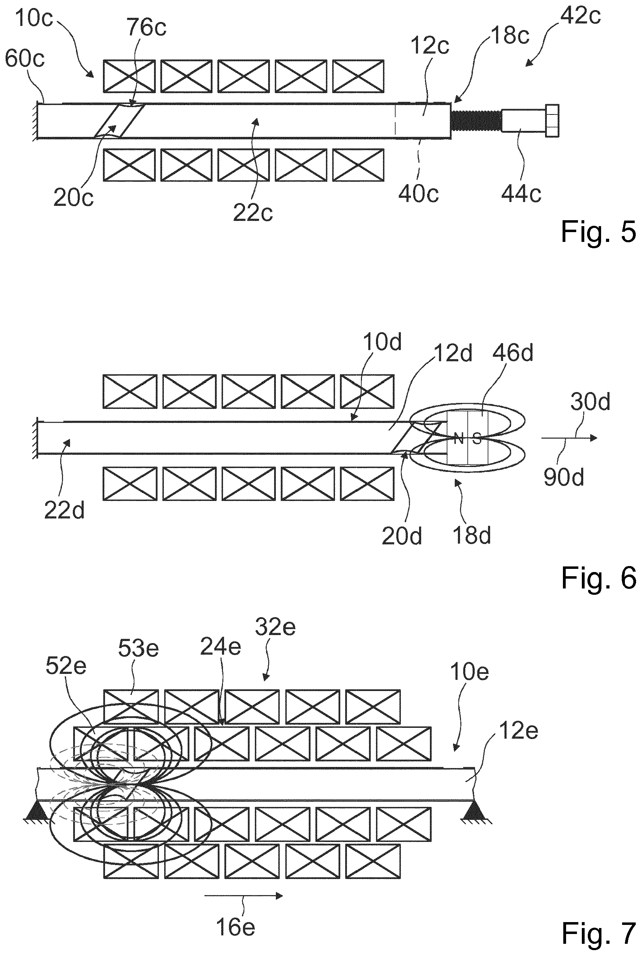

Fig. 5 zeigt ein weiteres Ausführungsbeispiel einer Verdrängungspumpenvorrichtung in einer schematischen Darstellung. Dieses unterscheidet sich im Wesentlichen durch eine Ausgestaltung einer Verformungseinheit 18c der Verdrängungspumpenvorrichtung.

Im vorliegenden Fall weist die Verformungseinheit 18c zumindest einen Mechanismus 42c auf. Der Mechanismus 42c ist zu einer mechanischen Verformung des magnetischen Formgedächtniselements 12c der Formgedächtniseinheit 10c der Verdrängungspumpenvorrichtung vorgesehen. Mittels des Mechanismus 42c kann das Formgedächtniselement 12c mit einer Druckkraft oder einer Zugkraft beaufschlagt werden. Der Mechanismus 42c ist an einem weiteren Endabschnitt 40c der Formgedächtniseinheit 10c angeordnet. Der Mechanismus 42c umfasst zumindest eine Einstellschraube 44c. Mittels der Einstellschraube 44c ist eine Druckkraft und/oder Zugkraft, mit welcher die Verformungseinheit 18c das Formgedächtniselement 12c beaufschlagt, einstellbar. Demnach ist über die Verformungseinheit 18c ein Verformungsgrad des Formgedächtniselements 12c einstellbar. Über den Verformungsgrad ist wiederum ein Fördervolumen 76c zwischen dem ersten Teilbereich 20c des Formgedächtniselements 12c und einem Mantel 60c der Formgedächtniseinheit 10c einstellbar.

Fig. 6 zeigt ein weiteres Ausführungsbeispiel einer Verdrängungspumpenvorrichtung in einer schematischen Darstellung. Dieses unterscheidet sich im Wesentlichen durch eine Ausgestaltung einer Verformungseinheit 18d der Verdrängungspumpenvorrichtung.

Im vorliegenden Fall ist die Verformungseinheit 18d als eine Magneteinheit ausgebildet. Die Verformungseinheit weist zumindest ein Magnetelement 46d auf. Das Magnetelement 88d wechselwirkt mit einem Formgedächtniselement 12d der Formgedächtniseinheit 10d der Verdrängungspumpenvorrichtung, und zwar insbesondere mit einem zweiten Teilbereich 22d des Formgedächtniselements 10d, welcher eine gleiche magnetische Orientierung 30d aufweist wie eine Magnetfeldhauptachse 90d des Magnetelements 46d. Das Formgedächtniselement 12d wird somit von dem Magnetelement 46d angezogen oder abgestoßen. Es stellt sich eine Druckkraft oder Zugkraft ein, mit welcher das Formgedächtniselement 12d mittels des Magnetelements 46d beaufschlagt ist. Das Magnetelement 88d ist an einem weiteren Endabschnitt 40d der Formgedächtniseinheit 10d angeordnet. Ferner könnte je ein Magnetelement an beiden Endabschnitten der Formgedächtniseinheit angeordnet sein.

Im vorliegenden Fall ist das Magnetelement 46d als ein dauermagnetisches Magnetelement ausgebildet. Es ist jedoch denkbar, insbesondere um einen Verformungsgrad einzustellen, dass das Magnetelement als ein elektromagnetisches Magnetelement ausgebildet sein könnte. Dadurch wären eine wirkende Magnetkraft und somit eine daraus resultierende Verformung des Formgedächtniselements über einen Strom und/oder eine Spannung, welche an dem Magnetelement anliegt, einstellbar.

Fig. 7 zeigt ein weiteres Ausführungsbeispiel einer Verdrängungspumpenvorrichtung in einer schematischen Darstellung. Dieses unterscheidet sich im Wesentlichen dadurch, dass die Verdrängungspumpenvorrichtung zumindest eine weitere Magneteinheit 32e umfasst.

Die weitere Magneteinheit 32e ist zumindest im Wesentlichen identisch zur Magneteinheit 24e der Verdrängungspumpenvorrichtung ausgebildet. Die weitere Magneteinheit 32e ist zumindest teilweise koaxial um die Magneteinheit 24e angeordnet. Die weitere Magneteinheit 32e ist entlang einer Förderrichtung 16e der Verdrängungspumpenvorrichtung zumindest teilweise versetzt zur Magneteinheit 24e angeordnet. Insbesondere sind weitere Magnetelemente 53e der weiteren Magneteinheit 32e entlang der Förderrichtung 16e versetzt zu den Magnetelementen 52e der Magneteinheit 24e angeordnet. Eine Steuereinheit der Verdrängungspumpenvorrichtung steuert separat abwechselnd die Magneteinheiten 24e, 32e an, so dass kaskadenartig die einzelnen Magnetelemente 52e, 53e der Magneteinheiten 24e, 32e aktiviert werden, um einen ersten Teilbereich eines Formgedächtniselements 12e der Formgedächtniseinheit 10e entlang der Förderrichtung 16e zu bewegen. Die Steuereinheit berücksichtigt bei einer Ansteuerung eine gegenseitige Induktion der Magnetelemente 52e, 53e der Magneteinheiten 24e, 32e untereinander, wodurch insbesondere eine vorteilhafte Energieeffizienz bei der Ansteuerung der Magneteinheiten 24e, 32e erzielt werden kann.

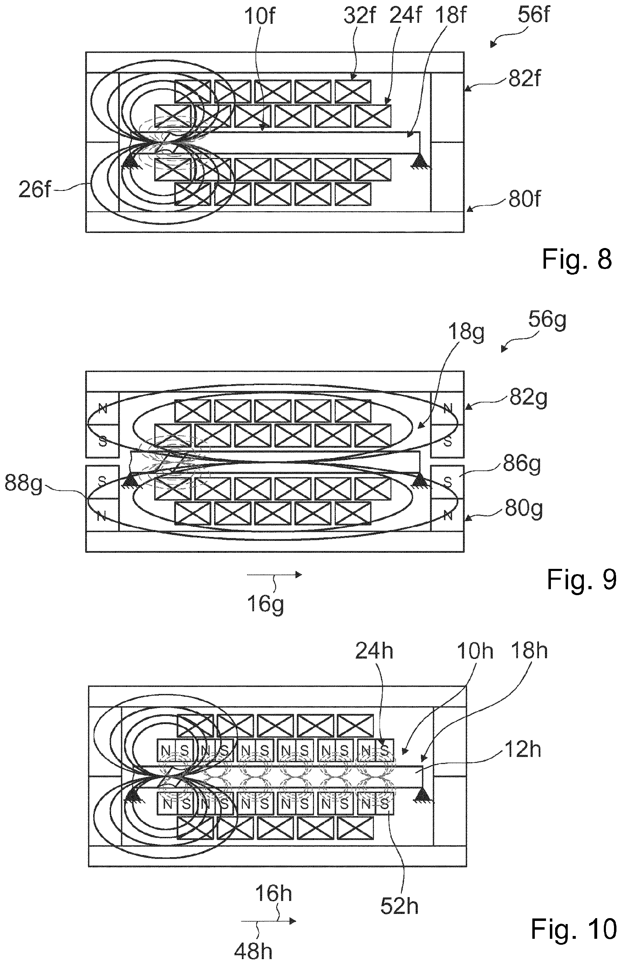

Fig. 8 zeigt ein weiteres Ausführungsbeispiel einer Verdrängungspumpenvorrichtung in einer schematischen Darstellung. Dieses unterscheidet sich im Wesentlichen dadurch, dass die Verdrängungspumpenvorrichtung zumindest eine Verstärkungseinheit 56f umfasst.

Die Verstärkungseinheit 56f ist dazu vorgesehen, ein von Magneteinheiten 24f, 32f der Verdrängungspumpenvorrichtung bereitgestelltes Magnetfeld 26f gezielt in eine Formgedächtniseinheit 10f der Verdrängungspumpenvorrichtung einzuleiten. Die Verstärkungseinheit 56f ist zumindest eine Verformungseinheit 18f und/oder eine Magneteinheit 24f, 32f der Verdrängungspumpenvorrichtung zumindest teilweise umgebend angeordnet.

Die Verstärkungseinheit 56f ist koaxial zur Formgedächtniseinheit 10f, der Verformungseinheit 18f, der Magneteinheit 24f und der weiteren Magneteinheit 43f angeordnet. Die Verstärkungseinheit 56f weist zumindest einen Magnetfeldkreis 80f, auf. Der Magnetfeldkreis 80f weist eine U-Form auf. Der Magnetfeldkreis 80f weist im vorliegenden Fall drei Magnetfeldelemente auf, welche die Schenkel der U-Form ausbilden. Alternativ könnte der Magnetfeldkreis auch einstückig ausgebildet sein.

Im vorliegenden Fall weist die Verstärkungseinheit 56f zwei Magnetfeldkreise 80f, 82f auf. Die Magnetfeldkreise 80f, 82f sind zumindest im Wesentlichen identisch zueinander ausgebildet. Die Magnetfeldkreise 80f, 82f sind spiegelsymmetrisch zueinander um die Formgedächtniseinheit 10f angeordnet. Eine Spiegelachse, an welcher die Magnetfeldkreise 80f, 82f gespiegelt sind, ist identisch mit einer Haupterstreckungsrichtung der Formgedächtniseinheit 10f.

Fig. 9 zeigt ein weiteres Ausführungsbeispiel einer Verdrängungspumpenvorrichtung in einer schematischen Darstellung. Dieses unterscheidet sich im Wesentlichen durch eine Ausgestaltung einer Verstärkungseinheit 56g der Verdrängungspumpenvorrichtung.

Die Verstärkungseinheit 56g weist zwei Magnetfeldkreise 80, 82 auf. Im vorliegenden Fall weist der Magnetfeldkreis 80g zwei Magnetelemente 86g, 88g auf. Die Magnetelemente 86g, 88g bilden jeweils einen Schenkel des Magnetfeldkreises 80g aus. Die Magnetelemente 86g, 88g sind als dauermagnetische Magnetelemente 86g, 88g ausgebildet. Alternativ könnten diese auch als elektromagnetische Magnetelemente ausgebildet sein.

Die Magnetelemente 86g, 88g sind dazu vorgesehen, den Magnetfeldkreis 80g zu magnetisieren. Die Magnetelemente 86g, 88g sind dabei in einem Nahbereich von Endabschnitten der Formgedächtniseinheit 10g angeordnet. Magnetfeldhauptachsen 87, 89 der einzelnen Magnetelemente 86g,88g sind dabei zumindest im Wesentlichen senkrecht zur Förderrichtung 16g. Im vorliegenden Fall bildet die Verstärkungseinheit 56g zumindest teilweise eine Verformungseinheit 18g der Verdrängungspumpenvorrichtung aus, da insbesondere die Magnetelemente 86g, 88g eine Druckkraft und/oder Zugkraft auf das Formgedächtniselement 12g der Formgedächtniseinheit 10g ausüben.

Fig. 10 zeigt ein weiteres Ausführungsbeispiel einer Verdrängungspumpenvorrichtung in einer schematischen Darstellung. Dieses unterscheidet sich im Wesentlichen durch eine Ausgestaltung einer Verformungseinheit 18h der Verdrängungspumpenvorrichtung.

Die Verformungseinheit 18h ist zumindest teilweise koaxial um ein Formgedächtniselement 12h einer Formgedächtniseinheit 10h der Verdrängungspumpenvorrichtung angeordnet. Im vorliegenden Fall bildet eine Magneteinheit 24h die Verformungseinheit 18h zumindest teilweise aus. Die Magnetelemente 52h der Magneteinheit 24h sind im vorliegenden Fall als dauermagnetische Magnetelemente 52h ausgebildet. Eine Magnetfeldhauptachse 48h der Magnetelemente 52h ist zumindest im Wesentlichen parallel zur Förderrichtung 16h.

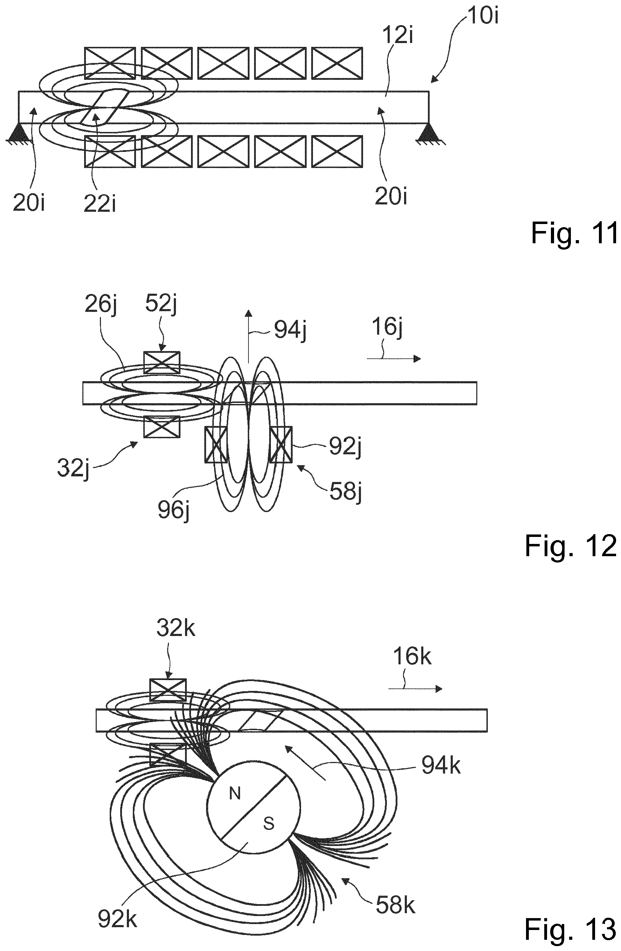

Fig. 11 zeigt ein weiteres Ausführungsbeispiel einer Verdrängungspumpenvorrichtung in einer schematischen Darstellung. Dieses unterscheidet sich im Wesentlichen durch eine Ausgestaltung von ersten Teilbereichen 20i und zweiten Teilbereichen 22i eines Formgedächtniselements 12i einer Formgedächtniseinheit 10i der Verdrängungspumpenvorrichtung.

Im vorliegenden Fall erstreckt sich der zweite Teilbereich 22i lediglich über einen Bruchteil 34i der Erstreckung des Formgedächtniselements 10i. Der erste Teilbereich 20i erstreckt sich über einen Großteil des Formgedächtniselements 12i. Ferner weist das Formgedächtniselement 12i im vorliegenden Fall einen zweiten Teilbereich 22i und zwei erste Teilbereiche 20i auf.

Fig. 12 zeigt ein weiteres Ausführungsbeispiel der Verdrängungspumpenvorrichtung in einer schematischen Darstellung. Dieses unterscheidet sich im Wesentlichen dadurch, dass die Verdrängungspumpenvorrichtung zumindest eine Ausgleichseinheit 58j umfasst.

Die Ausgleichseinheit 58j ist als eine Magneteinheit ausgebildet. Die Ausgleichseinheit 58j könnte als eine elektromagnetische und/oder dauermagnetische Magneteinheit ausgebildet sein. Im vorliegenden Fall ist die Ausgleichseinheit 58j als eine elektromagnetische Magneteinheit ausgebildet. Die Ausgleichseinheit 58j ist dazu vorgesehen, ein von einer Magneteinheit 32j der Verdrängungspumpenvorrichtung bereitgestelltes Magnetfeld 26j bei einer Bewegung dessen entlang der Förderrichtung 16j, wie beispielsweise beim Deaktivieren und Aktivieren verschiedener Magnetelemente 52j der Magneteinheit 24j, auszugleichen. Die Ausgleichseinheit 58j ist von einer Steuereinheit der Verdrängungspumpenvorrichtung separat ansteuerbar. Die Ausgleichseinheit 58j stellt ein Magnetfeld 96j bereit, welches eine Magnetfeldhauptachse 94j aufweist, die zumindest quer, vorzugsweise zumindest im Wesentlichen senkrecht zur Förderrichtung 16j ist. Demnach durchströmt das Magnetfeld 96j die Formgedächtniseinheit 10j zumindest teilweise quer zur Förderrichtung 16j. Ferner ist denkbar, dass die Magnetfeldhauptachse 94j der Ausgleichseinheit 58j drehbar ist. Beispielsweise kann diese durch verschiedene zueinander verdreht angeordnete Magnetelemente, insbesondere Spulen, erzielt werden, welche zueinander separat ansteuerbar sind. Ferner ist denkbar, dass die Ausgleichseinheit zumindest ein dauermagnetisches Magnetelement umfasst, welches selbst drehbar gelagert ist, um dieses insbesondere korrespondierend zu der Bewegung des Magnetfelds der Magneteinheit entlang der Förderrichtung zu drehen.

Fig. 13 zeigt ein weiteres Ausführungsbeispiel der Verdrängungspumpenvorrichtung in einer schematischen Darstellung. Dieses unterscheidet sich im Wesentlichen durch eine Ausgestaltung einer Ausgleichseinheit 58k der Verdrängungspumpenvorrichtung. Im vorliegenden Fall ist die Ausgleichseinheit 58k als eine dauermagnetische Magneteinheit ausgebildet. Die Ausgleichseinheit 58k weist zumindest ein dauermagnetisches Magnetelement 92k auf. Das Magnetelement 92k ist drehbar gelagert. Die Magnetelement 92k ist relativ zu einer Versorgungseinheit 58k der Verdrängungspumpenvorrichtung drehbar gelagert. Eine Drehachse um welche das Magnetelement 92k drehbar ist, ist zumindest im Wesentlichen senkrecht zu einer Förderrichtung 16k.

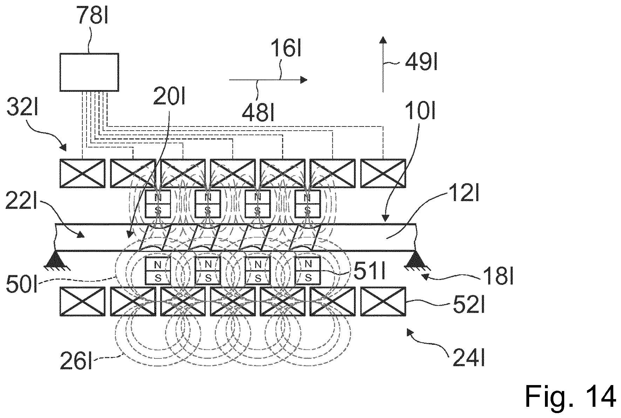

Fig. 14 zeigt ein weiteres Ausführungsbeispiel einer Verdrängungspumpenvorrichtung in einer schematischen Darstellung. Diese unterscheidet sich im Wesentlichen durch eine Ausgestaltung einer Verformungseinheit 18i der Verdrängungspumpenvorrichtung.

Im vorliegenden Fall ist die Verformungseinheit 18l als eine insbesondere dauermagnetische Magneteinheit 32l ausgebildet. Die Verformungseinheit 18l weist Magnetelemente 51l auf. Im vorliegenden Fall sind die Magnetelemente 511 als dauermagnetische Magnetelemente 51l ausgebildet. Die stellen jeweils ein Magnetfeld 50l bereit. Alternativ könnten die Magnetelemente auch als elektromagnetische Magnetelemente ausgebildet sein.

Eine jeweilige Magnetfeldhauptachse 49l des Magnetfelds 50l der Magnetelemente 51l ist zumindest im Wesentlichen senkrecht zur Förderrichtung 16l ausgerichtet. Derart orientieren die Magnetelemente 511 eine Anisotropie eines Formgedächtniselements 12l einer Formgedächtniseinheit 10l der Verdrängungspumpenvorrichtung um. Dies führt zur Bereitstellung einer Vielzahl von ersten Teilbereichen 20l. Um die ersten Teilbereiche 20l entlang der Förderrichtung 16l zu bewegen, wird eine Magneteinheit 24i der Verdrängungspumpenvorrichtung genutzt. Eine Steuereinheit 78l der Verdrängungspumpenvorrichtung steuert elektromagnetische Magnetelemente 52l der Magneteinheit 24l kaskadenartig alternierend an, dass ein jeweiliges, im Nahbereich des Magnetelements 51l der Verformungseinheit 18l angeordnetes elektromagnetisches Magnetelement 52l der Magneteinheit 24l ein Magnetfeld 26l erzeugt, welches eine Magnetfeldhauptachse 48i parallel zur Förderrichtung 16l aufweist. Im Vergleich dazu ist außerhalb des Nahbereichs durch die Magneteinheit 24l eine Magnetfeldhauptachse 49l senkrecht zur Förderrichtung 16l ausgerichtet ist. Durch eine derartige Ansteuerung kann durch Überlagerung der Magnetfelder 26l, 50l der erste Teilbereich 20l teilweise in den zweiten Teilbereich 22l oder umgekehrt überführt werden, wodurch sich insgesamt eine Bewegung der ersten Teilbereiche 20l in Förderrichtung 16l ergibt.

## Patentansprüche

1. Verdrängungspumpenvorrichtung mit zumindest einer Formgedächtniseinheit (10), welche zumindest ein magnetisches Formgedächtniselement (12) umfasst, welches dazu vorgesehen ist, zumindest ein Medium (14) entlang zumindest einer Förderrichtung (16) zu fördern, **gekennzeichnet durch** zumindest eine Verformungseinheit (18), welche dazu vorgesehen ist, das magnetische Formgedächtniselement (12) zur Bereitstellung eines Fördervolumens (76) zumindest in einem Ruhezustand, in welchem die Verdrängungspumpenvorrichtung frei von einer Strom- und/oder Spannungsversorgung ist, durch eine in Förderrichtung (16) wirkende Druckkraft und/oder Zugkraft derart zu verformen, dass dieses zumindest einen ersten Teilbereich (20) und zumindest einen zweiten Teilbereich (22) aufweist, welche sich zumindest durch eine magnetische Orientierung (28, 30) voneinander unterscheiden.

2. Verdrängungspumpenvorrichtung nach dem Oberbegriff des Anspruchs 1, insbesondere nach Anspruch 1, **gekennzeichnet durch** zumindest eine dauermagnetische Magneteinheit (24), welche dazu vorgesehen ist, zumindest in einem Ruhezustand, das magnetische Formgedächtniselement (12) mit einem Magnetfeld (26) zu beaufschlagen, so dass dieses zumindest einen ersten Teilbereich (20) und zumindest einen zweiten Teilbereich (22) aufweist, welche sich zumindest durch eine magnetische Orientierung (28, 30) voneinander unterscheiden, und durch eine elektromagnetische Magneteinheit (32), welche dazu vorgesehen ist, zumindest den ersten Teilbereich (20) in Förderrichtung (16) zu bewegen.

3. Verdrängungspumpenvorrichtung nach Anspruch 1 oder 2, **dadurch gekennzeichnet, dass** der erste Teilbereich (20) eine geringere Abmessung senkrecht zur Förderrichtung (16) aufweist als der zweite Teilbereich (22).

4. Verdrängungspumpenvorrichtung nach einem der vorhergehenden Ansprüche, **dadurch gekennzeichnet, dass** das magnetische Formgedächtniselement (12) zumindest zwei erste Teilbereiche (20) und zumindest zwei zweite Teilbereiche (22) aufweist.

5. Verdrängungspumpenvorrichtung nach einem der vorhergehenden Ansprüche, **dadurch gekennzeichnet, dass die** Verformungseinheit (18) zumindest teilweise an einem Endabschnitt (38, 40) des Formgedächtniselements (12) angeordnet ist.

6. Verdrängungspumpenvorrichtung nach einem der vorhergehenden Ansprüche, **dadurch gekennzeichnet, dass** die Verformungseinheit (18) zumindest teilweise koaxial um das magnetische Formgedächtniselement (12) angeordnet ist.

7. Verdrängungspumpenvorrichtung nach einem der vorhergehenden Ansprüche, **dadurch gekennzeichnet, dass** die Verformungseinheit (18) zur Einstellung verschiedener Verformungsgrade einer Verformung des magnetischen Formgedächtniselements (12) vorgesehen ist.

8. Verdrängungspumpenvorrichtung nach einem der vorhergehenden Ansprüche, **dadurch gekennzeichnet, dass** die Verformungseinheit (18) zumindest einen Mechanismus (42) aufweist, welcher zur mechanischen Verformung das magnetische Formgedächtniselement (12) mit einer Druckkraft oder einer Zugkraft beaufschlagt.

9. Verdrängungspumpenvorrichtung nach Anspruch 8, **dadurch gekennzeichnet, dass** der Mechanismus (42) zumindest eine Einstellschraube (44) umfasst.

10. Verdrängungspumpenvorrichtung nach einem der vorhergehenden Ansprüche, **dadurch gekennzeichnet, dass** die Verformungseinheit (18) zumindest ein insbesondere dauermagnetisches Magnetelement (46) umfasst.

11. Verdrängungspumpenvorrichtung nach einem der vorhergehenden Ansprüche, **dadurch gekennzeichnet, dass** eine Magnetfeldhauptachse (48) eines von der Verformungseinheit (18) bereitgestellten Magnetfelds (50) zumindest im Wesentlichen parallel zur Förderrichtung (16) orientiert ist.

12. Verdrängungspumpenvorrichtung nach einem der vorhergehenden Ansprüche, **gekennzeichnet durch** zumindest eine Magneteinheit (24), welche dazu vorgesehen ist, zumindest den ersten Teilbereich entlang der Förderrichtung zu bewegen, und/oder welche zumindest teilweise koaxial um das magnetische Formgedächtniselement (12) angeordnet ist.

13. Verdrängungspumpenvorrichtung nach Anspruch 12, **dadurch gekennzeichnet, dass** die Magneteinheit (24) zumindest ein Magnetelement (52) aufweist, welches als ein elektromagnetisches Magnetelement (52), ausgebildet ist.

14. Verdrängungspumpenvorrichtung nach einem der Ansprüche 12 bis 13, **dadurch gekennzeichnet, dass** die Magneteinheit (24) zumindest ein erstes Magnetelement (52) und ein zweites Magnetelement (52) aufweist, welche entlang einer Förderrichtung (16) versetzt zueinander angeordnet sind und/oder welche separat voneinander ansteuerbar sind.

15. Verdrängungspumpenvorrichtung nach einem der Ansprüche 12 bis 14, **gekennzeichnet durch** zumindest eine weitere Magneteinheit (32).

16. Verdrängungspumpenvorrichtung nach Anspruch 15, **dadurch gekennzeichnet, dass** die weitere Magneteinheit (32) entlang der Förderrichtung (16) zumindest teilweise versetzt zur Magneteinheit (24) angeordnet ist und/oder dass die weitere Magneteinheit (32) zumindest teilweise koaxial um die Magneteinheit (24) angeordnet ist.

17. Verdrängungspumpenvorrichtung zumindest nach Anspruch 12,
**gekennzeichnet durch** zumindest eine Verstärkungseinheit (56), welche dazu vorgesehen ist, ein von der Verformungseinheit (18) und/oder der Magneteinheit (24) bereitgestelltes Magnetfeld (26) zu verstärken.

18. Verdrängungspumpenvorrichtung nach Anspruch 17, **dadurch gekennzeichnet, dass** die Verstärkungseinheit (56) zumindest die Verformungseinheit (18) und/oder die Magneteinheit (24) zumindest teilweise umgebend angeordnet ist.

19. Verdrängungspumpenvorrichtung nach einem der vorhergehenden Ansprüche, **gekennzeichnet durch** eine Ausgleichseinheit (58), welche zumindest ein Magnetfeld (60) bereitstellt, welches die Formgedächtniseinheit (10) durchströmt und eine Magnetfeldhauptachse (94) umfasst, welche zumindest quer zur Förderrichtung (16) orientiert ist.

20. Verdrängungspumpenvorrichtung nach einem der vorhergehenden Ansprüche, **dadurch gekennzeichnet, dass** die Formgedächtniseinheit (10) einen Mantel (66) aufweist, welcher dazu vorgesehen ist, das Formgedächtniselement (12) abzudichten.

21. Verdrängungspumpenvorrichtung nach Anspruch 20, **dadurch gekennzeichnet, dass** das Formgedächtniselement (12) zumindest zu einem Großteil, besonders bevorzugt vollständig, von dem Mantel (66) umgeben ist.

22. Verdrängungspumpenvorrichtung nach Anspruch 20 oder 21, **dadurch gekennzeichnet, dass** der Mantel (66) elastisch verformbar ist.

23. Verfahren zum Betrieb einer Verdrängungspumpenvorrichtung, insbesondere einer Verdrängungspumpenvorrichtung nach einem der Ansprüche 1 bis 22, bei dem ein Medium (14) zumindest von einem magnetischen Formgedächtniselement (12) zumindest einer Formgedächtniseinheit (10) zumindest entlang zumindest einer Förderrichtung (16) gefördert wird, **dadurch gekennzeichnet, dass** in zumindest einem Verfahrensschritt das magnetische Formgedächtniselement (12) zumindest in einem Ruhezustand, in welchem die Verdrängungspumpenvorrichtung frei von einer Strom- und/oder Spannungsversorgung ist, derart mittels einer Druckkraft und/oder Zugkraft entlang der Förderrichtung (16) verformt wird, dass dieses zumindest einen ersten Teilbereich (20) und zumindest einen zweiten Teilbereich (22) aufweist, welche sich zumindest durch eine magnetische Orientierung (28, 30) voneinander unterscheiden.

24. Verfahren zumindest nach dem Oberbegriff des Anspruchs 23, insbesondere nach Anspruch 23, **dadurch gekennzeichnet, dass** in zumindest einem Verfahrensschritt das magnetische Formgedächtniselement (12) von zumindest einer dauermagnetischen Magneteinheit (24) mit einem Magnetfeld (26) beaufschlagt wird, so dass dieses zumindest einen ersten Teilbereich (20) und zumindest einen zweiten Teilbereich (22) aufweist, welche sich zumindest durch eine magnetische Orientierung (28, 30) voneinander unterscheiden, und dass zumindest der erste Teilbereich (20) von zumindest einer elektromagnetischen Magneteinheit (32) in Förderrichtung (16) bewegt wird.

## Claims

1. Positive-displacement pump device
with at least one shape-memory unit (10) comprising at least one magnetic shape-memory element (12), which is configured for conveying at least one medium (14) along at least one conveying direction (16),
**characterized by** at least one deformation unit (18) which is configured, in order to provide a conveying volume (76) at least in a rest state, in which the positive-displacement pump device is free of a current and/or voltage supply, to deform the magnetic shape-memory element (12) by a pressure force and/or tensile force acting in the conveying direction (16) in such a way that the magnetic shape-memory element (12) has at least one first partial region (20) and at least one second partial region (22) differing from each other at least by a magnetic orientation (28, 30).

2. Positive-displacement pump device according to the preamble of claim 1, in particular according to claim 1,
**characterized by** at least one permanent-magnetic magnet unit (24) which is configured, at least in a rest state, to apply a magnetic field (26) to the magnetic shape-memory element (12) such that the magnetic shape-memory element (12) has at least one first partial region (20) and at least one second partial region (22) differing from each other at least by a magnetic orientation (28, 30),
and by an electromagnetic magnet unit (32), which is configured for moving at least the first partial region (20) in the conveying direction (16).

3. Positive-displacement pump device according to claim 1 or 2,
**characterised in that** the first partial region (20) has a smaller dimension perpendicular to the conveying direction (16) than the second partial region (22).

4. Positive-displacement pump device according to one of the preceding claims,
**characterised in that** the magnetic shape-memory element (12) comprises at least two first partial regions (20) and at least two second partial regions (22).

5. Positive-displacement pump device according to one of the preceding claims,
**characterised in that** the deformation unit (18) is arranged at least partially on an end section (38, 40) of the shape-memory element (12).

6. Positive-displacement pump device according to one of the preceding claims,
**characterised in that** the deformation unit (189 is arranged at least partially coaxially around the magnetic shape-memory element (12).

7. Positive-displacement pump device according to one of the preceding claims,
**characterised in that** the deformation unit (18) is configured for an adjustment of different deformation degrees of a deformation of the magnetic shape-memory element (12).

8. Positive-displacement pump device according to one of the preceding claims,
**characterised in that** the deformation unit (18) comprises at least one mechanism (42) which applies a pressure force or a tensile force to the magnetic shape-memory element (12) for the mechanical deformation.

9. Positive-displacement pump device according to claim 8,
**characterised in that** the mechanism (42) comprises at least one adjustment screw (44).

10. Positive-displacement pump device according to one of the preceding claims,
**characterised in that** the deformation unit (18) comprises at least one, in particular permanent-magnetic, magnet element (46).

11. Positive-displacement pump device according to one of the preceding claims,
**characterised in that** a principal magnetic field axis (48) of a magnetic field (50) provided by the deformation unit (18) is oriented at least substantially parallel to the conveying direction (16).

12. Positive-displacement pump device according to one of the preceding claims,
**characterised by** at least one magnet unit (24), which is configured for moving at least the first partial region (20) along the conveying direction (16), and/or which is arranged at least partially coaxially around the magnetic shape-memory element (12).

13. Positive-displacement pump device according to claim 12,
**characterised in that** the magnet unit (24) comprises at least one magnet element (52) which is realized as an electromagnetic magnet element (52).

14. Positive-displacement pump device according to one of claims 12 to 13, **characterised in that** the magnet unit (24) comprises at least one first magnet element (52) and a second magnet element (52), which are arranged offset to each other along a conveying direction (16) and/or are actuatable separately from each other.

15. Positive-displacement pump device according to one of claims 12 to 14, **characterised by** at least one further magnet unit (32).

16. Positive-displacement pump device according to claim 15,
**characterised in that** the further magnet unit (32) is arranged at least partially offset to the magnet unit (24) along the conveying direction (16), and/or that the further magnet unit (32) is arranged at least partially coaxially around the magnet unit (24).

17. Positive-displacement pump device at least according to claim 12, **characterised by** at least one amplification unit (56), which is configured to amplify a magnetic field (26) provided by the deformation unit (18) and/or by the magnet unit (24).

18. Positive-displacement pump device according to claim 17,
**characterised in that** the amplification unit (56) is arranged at least partially surrounding at least the deformation unit (18) and/or the magnet unit (24).

19. Positive-displacement pump device according to one of the preceding claims,
**characterised by** a compensation unit (58) providing at least one magnetic field (60) which flows through the shape-memory unit (10) und comprises a principal magnetic field axis (94) that is oriented at least transversally to the conveying direction (16).

20. Positive-displacement pump device according to one of the preceding claims,
**characterised in that** the shape-memory unit (10) comprises an envelope (66), which is configured for sealing the shape-memory element (12) off.

21. Positive-displacement pump device according to claim 20,
**characterised in that** the shape-memory element (12) is surrounded by the envelope (66) at least to a large extent, particularly preferably completely.

22. Positive-displacement pump device according to claim 20 or 21, **characterised in that** the envelope (66) is elastically deformable.

23. Method for operating a positive-displacement pump device, in particular a positive-displacement pump device according to one of claims 1 to 22, in which a medium (14) is conveyed at least along at least one conveying direction (16) at least by a magnetic shape-memory element (12) of at least one shape-memory unit (10),
**characterised in that** in at least one method step, at least in a rest state in which the positive-displacement pump device is free of a current and/or voltage supply, the magnetic shape-memory element (12) is deformed by means of a pressure force and/or tensile force along the conveying direction (16) in such a way that the magnetic shape-memory element (12) has at least one first partial region (20) and at least one second partial region (22) differing from each other at least by a magnetic orientation (28, 30).

24. Method at least according to the preamble of claim 23, in particular according to claim 23,
**characterised in that** in at least one method step the magnetic shape-memory element (12) is subjected to a magnetic field (26) by at least one permanent-magnetic magnet unit (24)
such that the magnetic shape-memory element (12) has at least one first partial region (20) and at least one second partial region (22) differing from each other at least by a magnetic orientation (28, 30),
and that at least the first partial region (20) is moved in the conveying direction (16) by at least one electromagnetic magnet unit (32).

## Revendications

1. Dispositif de pompe volumétrique
avec au moins une unité à mémoire de forme (10) comprenant au moins un élément à mémoire de forme magnétique (12) qui est prévu pour transporter au moins un médium (14) le long d'au moins une direction de transport (16), **caractérisé par** au moins une unité à déformation (18) qui est prévue, afin de fournir un volume de transport (76), au moins dans un état de repos, dans lequel le dispositif de pompe volumétrique est dépourvu d'une alimentation en courant et/ou en voltage, pour déformer l'élément à mémoire de forme magnétique (12) par une force de pression et/ou force de traction agissant dans la direction de transport (16) d'une telle manière que ledit élément à mémoire de forme magnétique (12) comporte au moins une première zone partielle (20) et au moins une deuxième zone partielle (22) qui diffèrent l'une de l'autre au moins par une orientation magnétique (28, 30).

2. Dispositif de pompe volumétrique selon le préambule de la revendication 1, en particulier selon la revendication 1,
**caractérisé par** au moins une unité d'aimant permanent (24) qui est prévue, au moins dans un état de repos, pour appliquer un champ magnétique (26) à l'élément à mémoire de forme magnétique (12) en sorte que celui comporte au moins une première zone partielle (20) et au moins une deuxième zone partielle (22) qui différent l'une de l'autre au moins par une orientation magnétique (28, 30), et par une unité d'aimant électromagnétique (32) qui est prévue pour mouvoir au moins la première zone partielle (20) dans la direction de transport (16).

3. Dispositif de pompe volumétrique selon la revendication 1 ou 2,
**caractérisé en ce que** la première zone partielle (20) a une dimension perpendiculaire à la direction de transport (16) qui est inférieure à celle de la deuxième zone partielle (22).

4. Dispositif de pompe volumétrique selon l'une des revendications précédentes, **caractérisé en ce que** l'élément à mémoire de forme magnétique (12) comporte au moins deux premières zones partielles (20) et au moins deux deuxièmes zones partielles (22).

5. Dispositif de pompe volumétrique selon l'une des revendications précédentes, **caractérisé en ce que** l'unité à déformation (18) est disposée au moins partiellement sur une portion d'extrémité (38, 40) de l'élément à mémoire de forme (12).

6. Dispositif de pompe volumétrique selon l'une des revendications précédentes, **caractérisé en ce que** l'unité à déformation (18) est disposée au moins partiellement coaxialement autour de l'élément à mémoire de forme magnétique (12).

7. Dispositif de pompe volumétrique selon l'une des revendications précédentes, **caractérisé en ce que** l'unité à déformation (18) est prévue pour le réglage de degrés de déformation différents d'une déformation de l'élément à mémoire de forme magnétique (12).

8. Dispositif de pompe volumétrique selon l'une des revendications précédentes, **caractérisé en ce que** l'unité à déformation (18) comprend au moins un mécanisme (42) qui applique une force de pression ou une force de traction sur l'élément à mémoire de forme magnétique (12) pour la déformation mécanique.

9. Dispositif de pompe volumétrique selon la revendication 8,
**caractérisé en ce que** le mécanisme (42) comprend au moins une vis de réglage (44).

10. Dispositif de pompe volumétrique selon l'une des revendications précédentes, **caractérisé en ce que** l'unité à déformation (18) comprend au moins un élément d'aimant (46), en particulier élément d'aimant permanent.

11. Dispositif de pompe volumétrique selon l'une des revendications précédentes, **caractérisé en ce qu'**un axe principal de champ magnétique (48) d'un champ magnétique (50) fourni par l'unité à déformation (18) est orientée au moins sensiblement en parallèle à la direction de transport (16).

12. Dispositif de pompe volumétrique selon l'une des revendications précédentes, **caractérisé par** au moins une unité d'aimant (24) qui est prévue pour mouvoir au moins la première zone partielle le long de la direction de transport et/ou qui est disposée au moins partiellement coaxialement autour de l'élément à mémoire de forme magnétique (12).

13. Dispositif de pompe volumétrique selon la revendication 12,
**caractérisé en ce que** l'unité d'aimant (24) comprend au moins un élément d'aimant 52) qui est réalisé comme élément d'aimant électromagnétique (52).

14. Dispositif de pompe volumétrique selon l'une des revendications 12 à 13, **caractérisé en ce que** l'unité d'aimant (24) comprend au moins un premier élément d'aimant (52) et un deuxième élément d'aimant (52), qui sont disposés en décalé l'un par rapport à l'autre le long d'une direction de transport (16) et/ou qui peuvent être actionnés séparément l'un de l'autre.

15. Dispositif de pompe volumétrique selon l'une des revendications 12 à 14, **caractérisé par** au moins une autre unité d'aimant (32).

16. Dispositif de pompe volumétrique selon la revendication 15,
**caractérisé en ce que** l'autre unité d'aimant (32) est disposée au moins partiellement en décalé par rapport à l'unité d'aimant (24) dans la direction de transport (16) et/ou que l'autre unité d'aimant (32) est disposée au moins partiellement coaxialement autour de l'unité d'aimant (24).

17. Dispositif de pompe volumétrique au moins selon la revendication 12,
**caractérisé par** au moins une unité amplificatrice (56) qui est prévue pour amplifier un champ magnétique (26) fourni par l'unité à déformation (18) et/ou par l'unité d'aimant (24).

18. Dispositif de pompe volumétrique selon la revendication 17,
**caractérisé en ce que** l'unité amplificatrice (56) est disposée de telle manière qu'elle entoure au moins partiellement au moins l'unité à déformation (18) et/ou l'unité d'aimant (24).

19. Dispositif de pompe volumétrique selon l'une des revendications précédentes, **caractérisé par** une unité compensatrice (58) qui fournit au moins un champ magnétique (60) s'écoulant à travers l'unité à mémoire de forme (10) et ayant un axe principal de champ magnétique (94) qui est orienté au moins transversalement par rapport à la direction de transport (16).

20. Dispositif de pompe volumétrique selon l'une des revendications précédentes, **caractérisé en ce que** l'unité à mémoire de forme (10) comporte une enveloppe (66) qui est prévue pour étancher l'élément à mémoire de forme (12).

21. Dispositif de pompe volumétrique selon la revendication 20,
**caractérisé en ce que** l'élément à mémoire de forme (12) est entouré au moins en grande partie, particulièrement préférablement en entier, par l'enveloppe (66).

22. Dispositif de pompe volumétrique selon la revendication 20 ou 21,
**caractérisé en ce que** l'enveloppe (66) est élastiquement déformable.

23. Procédé en fonctionnement d'un dispositif de pompe volumétrique, en particulier un dispositif de pompe volumétrique selon l'une des revendications 1 à 22, dans lequel un médium (14) est transporté au moins le long d'au moins une direction de transport (16) au moins par un élément à mémoire de forme magnétique (12) d'au moins une unité à mémoire de forme (10),
**caractérisé en ce que** dans au moins une étape de procédé, au moins dans un état de repos dans lequel le dispositif de pompe volumétrique est dépourvu d'une alimentation en courant et/ou en voltage, l'élément à mémoire de forme magnétique (12) est déformé le long de la direction de transport (16) par le biais d'une force d pression et/ou force de traction d'une telle manière que ledit élément à mémoire de forme magnétique (12) comporte au moins une première zone partielle (20) et au moins une deuxième zone partielle (22) qui diffèrent l'une de l'autre au moins par une orientation magnétique (28, 30).

24. Procédé au moins selon le préambule de la revendication 23, en particulier selon la revendication 23,
**caractérisé en ce que** dans au moins une étape de procédé l'élément à mémoire de forme magnétique (12) est soumis à un champ magnétique (26) par au moins une unité d'aimant permanent (24) en sorte que celui comporte au moins une première zone partielle (20) et au moins une deuxième zone partielle (22) qui différent l'une de l'autre au moins par une orientation magnétique (28, 30),
et qu'au moins la première zone partielle (20) est mue dans la direction de transport (16) par au moins une unité d'aimant électromagnétique (32).
